# EUROPEAN PATENT APPLICATION

(11) **EP 4 629 766 A1**
(43) Date of publication of application: **08.10.2025**
(21) Application number: 24809529.1
(22) Date of filing: 25.11.2024
(51) Int. Cl.: H05K 7/20

(54) **ELECTRONIC DEVICE INCLUDING STRUCTURE FOR HEAT DISSIPATION**

(30) Priority: 23.02.2024 KR 20240026649; 16.04.2024 KR 20240051032
(71) Applicant: Samsung Electronics Co., Ltd., Suwon-si, Gyeonggi-do 16677 (KR)
(72) Inventor: The designation of the inventor has not yet been filed
(74) Representative: HGF
(86) International application number: PCT/KR2024/018778
(87) International publication number: WO 2025/178207

(57) **Abstract**

According to an embodiment, an electronic device includes a heat generating component, and a vapor chamber, disposed over the heat generating component. The vapor chamber includes an enclosure, a fluid in the enclosure, and a wick structure in the enclosure. The wick structure includes a first portion disposed at least partially over the heat generating component, a second portion configured to absorb the fluid of a liquid state, and a third portion disposed between the first portion and the second portion. A width of the enclosure surrounding the third portion is smaller than a width of the enclosure surrounding the second portion. The second portion includes one or more stem portions extending from the third portion, and a plurality of branch portions extending from the one or more stem portions. A counted number of the plurality of branch portions of the second portion is greater than a counted number of the one or more stem portions.

## Description

### [Technical Field]

The present disclosure relates to an electronic device including a structure for heat dissipation.

### [Background Art]

An electronic device may include various electronic components to meet a user's need. The electronic device may be miniaturized to be worn by the user or portable by the user. As the electronic components disposed in the electronic device perform an operation for responding to a user's request, heat may be generated in the miniaturized electronic device. The electronic device may include a structure for dissipating heat in the electronic device.

The above-described information may be provided as a related art for the purpose of helping to understand the present disclosure. No claim or determination is raised as to whether any of the above-described information may be applied as a prior art related to the present disclosure.

### [Disclosure]

### [Technical Solution]

An electronic device is disclosed. According to an embodiment, the electronic device may include a heat generating component, and a vapor chamber, disposed over the heat generating component. The vapor chamber may include the enclosure, the fluid in the enclosure, and the wick structure in the enclosure. The wick structure may include a first portion disposed at least partially over the heat generating component. A state of the fluid positioned in the first portion may be changed from a liquid state to a gaseous state by heat transmitted from the heat generating component to the first portion. The fluid of the gaseous state may diffuse to an internal space of the enclosure. The wick structure may include a second portion configured to absorb the fluid of the liquid state changed, within the internal space of the enclosure, from the gaseous state. The wick structure may include a third portion disposed between the first portion and the second portion. The fluid of the liquid state absorbed by the second portion may be moved through the third portion to the first portion. A width of a portion of the internal space of the enclosure surrounding the third portion may be smaller than a width of a portion of the internal space of the enclosure surrounding the second portion. The third portion may include one or more elongated stem portions extending from the first portion. The second portion may include one or more elongated stem portions extending from the one or more elongated stem portions of the third portion. The second portion may include a plurality of branch portions extending from the one or more elongated stem portions of the second portion. The plurality of branch portions may be spaced apart from each other. A counted number of the plurality of branch portions of the second portion may be greater than a counted number of the one or more elongated stem portions of the third portion.

Anelectronic device is disclosed. According to an embodiment, the electronic device may include a heat generating component, and a vapor chamber. The vapor chamber may define an internal space disposed over the heat generating component, and include an enclosure including a first plate, and a second plate coupled on the first plate to seal the internal space. The vapor chamber may include a fluid within the internal space and a wick structure within the internal space for cooling the heating component. The internal space may include a first space, at least partially disposed over the heat generating component for vaporization of the fluid by receiving heat emitted from the heat generating component. The internal space may include a second space spaced apart from the first space for condensation of the fluid. The internal space may include a third space connecting the first space and the second space, and having a smaller width than the second space. The wick structure may include a first portion disposed within the first space and in which the fluid within the first space is changed from a liquid state to a gaseous state. The wick structure may include one or more stem portions extending from the first portion, across the third space, to the second space, and a second portion including a plurality of branch portions branching from the one or more stem portions to increase absorption of a fluid in the liquid state condensed within the second space. The first portion may be attached to the first plate and may be spaced apart from the second plate within the internal space. The second portion may be interposed between the first plate and the second plate within the internal space.

An electronic device is disclosed. According to an embodiment, the electronic device may include an electronic component, an enclosure defining a space for a fluid on the electronic component, and a vapor chamber including a wick structure disposed within the space. The enclosure may include a first region at least partially disposed over the electronic component to receive heat emitted from the electronic component, a second region spaced apart from the first region, and a third region connecting the first region and the second region, having smaller internal volume than the second region. The wick structure may include a first portion disposed in the first region, and a second portion extending from the first portion, across the third region, to the second region. A counted number of first end portions of the second portion disposed in the second region may be greater than a counted number of second end portions of the second portion connected to the first portion disposed in the first region to absorb the fluid in the second region.

An electronic device is disclosed. An electronic device according to an embodiment may include an electronic component. The electronic device may include a first plate, a second plate coupled on the first plate, an enclosure including a space for a fluid on the electronic component between the first plate and the second plate, and a vapor chamber including a wick structure disposed within the space. The enclosure may define a first region at least partially disposed over the electronic component to receive heat emitted from the electronic component, a second region spaced apart from the first region, and a third region connecting the first region and the second region, having smaller internal volume than the second region. The wick structure may include a first portion disposed in the first region, and a second portion including one or more stem portions extending from the first portion, across the third region, to the second region, and a plurality of branch portions branching respectively from the one or more stem portions in the second region. The first portion may be spaced apart from the second plate by being attached to the first plate within the space. The second portion may be interposed between the first plate and the second plate to be attached to the first plate and the second plate within the space.

### [Description of the Drawings]

With respect to a description of a drawing, the same or a similar reference numeral may be used for the same or a similar component.
FIG. 1 is a block diagram of an electronic device in a network environment according to various embodiments.
FIG. 2A is a drawing illustrating an electronic device according to an embodiment.
FIG. 2B is an exploded perspective view of an electronic device according to an embodiment.
FIG. 3A illustrates a portion of an exemplary electronic device.
FIG. 3B illustrates a portion of a vapor chamber of an exemplary electronic device.
FIG. 4A is an exploded perspective view of a vapor chamber of an exemplary electronic device.
FIG. 4B illustrates a portion of a vapor chamber of an exemplary electronic device.
FIG. 5A, FIG. 5B, and FIG. 5C illustrate a portion of a wick structure of an exemplary vapor chamber.
FIG. 6A and FIG. 6B are a partial cross-sectional view of an exemplary vapor chamber cut along line A-A' of FIG. 4B.
FIG. 6C is a cross-sectional view of an exemplary vapor chamber cut along line B-B' of FIG. 4B.

### [Mode for Invention]

Hereinafter, an embodiment of the present disclosure will be described in detail with reference to a drawing so that those having ordinary knowledge in the art may easily implement the present disclosure. However, the present disclosure may be implemented in several different forms and is not limited to an embodiment described herein. With respect to a description of a drawing, the same or a similar reference numeral may be used for the same or a similar component. In addition, in the drawing and a related description, the description of a well-known function and configuration may be omitted for clarity and brevity.

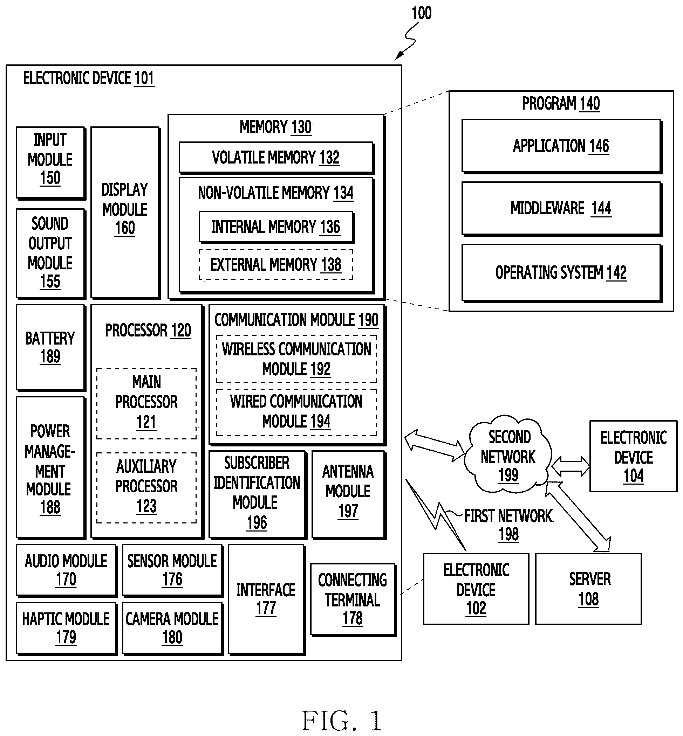

FIG. 1 is a block diagram illustrating an electronic device in a network environment according to various embodiments.

Referring to FIG. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, an HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

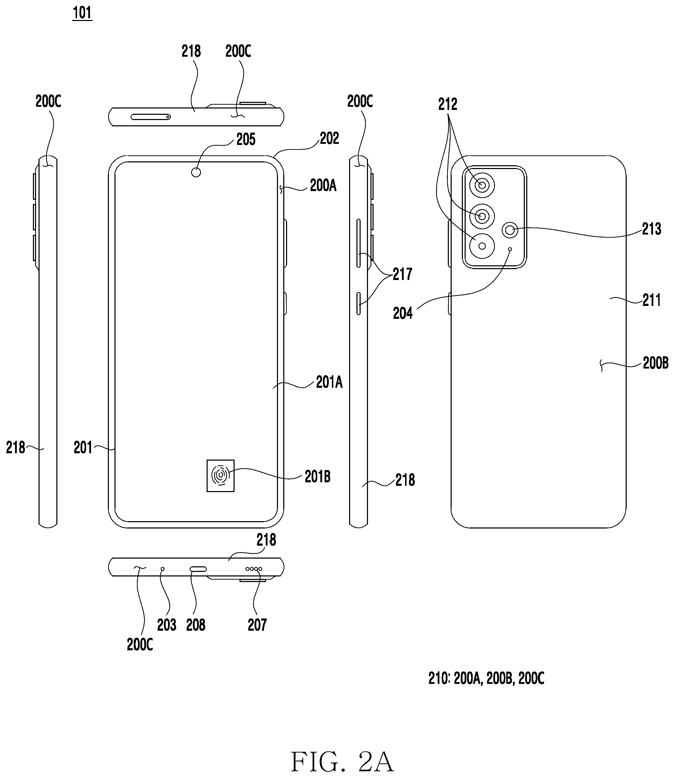

FIG. 2A is a drawing illustrating an electronic device according to an embodiment.

Referring to FIG. 2A, an electronic device 101 according to an embodiment may include a housing assembly 210 forming an exterior of the electronic device 101. For example, the housing assembly 210 may include a front surface 200A, a rear surface 200B, and a side surface 200C surrounding a space between the front surface 200A and the rear surface 200B. According to an embodiment, the housing assembly 210 may refer to a structure forming at least a portion of the front surface 200A, the rear surface 200B, and/or the side surface 200C.

According to an embodiment, the electronic device 101 may include a substantially transparent front plate 202. According to an embodiment, the front plate 202 may form at least a portion of the front surface 200A. For example, according to an embodiment, the front plate 202 may include a glass plate or a polymer plate including various coating layers, but is not limited to thereto.

According to an embodiment, the electronic device 101 may include a substantially opaque rear plate 211. According to an embodiment, the rear plate 211 may form at least a portion of the rear surface 200B. According to an embodiment, the rear plate 211 may be formed of coated or colored glass, ceramic, a polymer, metal (e.g., aluminum, stainless steel (STS), or magnesium), or a combination of at least two of the materials.

The electronic device 101 according to an embodiment may include a frame (or a side bezel structure) 218. According to an embodiment, the frame 218 may form at least a portion of the side surface 200C of the electronic device 101 by being coupled to the front plate 202 and/or the rear plate 211. For example, a frame 218 may form the entire side surface 200C of the electronic device 101, and for another example, the frame 218 may form the side surface 200C of the electronic device 101 together with the front plate 202 and/or the rear plate 211.

Unlike the illustrated embodiment, in case that the side surface 200C of the electronic device 101 is partially formed by the front plate 202 and/or the rear plate 211, the front plate 202 and/or the rear plate 211 may include a region that is bent from a periphery thereof toward the rear plate 211 and/or the front plate 202 and is seamlessly extended. For example, the extended region of the front plate 202 and/or the rear plate 211 may be positioned at both ends of a long edge of the electronic device 101 but is not limited by the above-described example.

According to an embodiment, the frame 218 may include metal and/or a polymer. According to an embodiment, the rear plate 211 and the frame 218 may be integrally formed, and may include the same material (e.g., a metal material such as aluminum), but are not limited thereto. For example, the rear plate 211 and the frame 218 may be formed in a separate configuration and/or may include a different material.

According to an embodiment, the electronic device 101 may include at least one of a display 201, an audio module 203, 204, and 207, a sensor module (not illustrated), a camera module 205, 212, and 213, a key input device 217, a light emitting element (not illustrated), and/or a connector hole 208. According to an embodiment, the electronic device 101 may omit at least one (e.g., the key input device 217 or the light emitting device (not illustrated)) of the components or may additionally include another component.

According to an embodiment, the display 201 (e.g., the display module 160 of FIG. 1), may be visually exposed through a large portion of the front plate 202. For example, at least a portion of the display 201 may be visible through the front plate 202 forming the front surface 200A. According to an embodiment, the display 201 may be disposed at a back surface of the front plate 202.

According to an embodiment, an outer shape of the display 201 may be formed generally the same as an outer shape of the front plate 202 adjacent to the display 201. According to an embodiment, in order to expand an area in which the display 201 is visually exposed, a distance between the outer periphery of the display 201 and the outer periphery of the front plate 202 may be formed generally the same.

According to an embodiment, the display 201 (or the front surface 200A of the electronic device 101) may include a screen display region 201A. According to an embodiment, the display 201 may provide visual information to a user through the screen display region 201A. In the illustrated embodiment, when the front surface 200A is viewed frontally, the screen display region 201A is illustrated to be spaced apart from the outer periphery of the front surface 200A and positioned inside the front surface 200A, but is not limited thereto. In another embodiment, when the front surface 200A is viewed frontally, at least a portion of a periphery part of the screen display region 201A may substantially coincide with the periphery part of the front surface 200A (or the front plate 202).

According to an embodiment, the screen display region 201A may include a sensing region 201B configured to obtain a biometric information of the user. Here, the meaning of "the screen display region 201A includes the sensing region 201B" may be understood to mean that at least a portion of the sensing area 201B may be overlapped on the screen display area 201A. For example, the sensing region 201B may mean a region capable of displaying visual information by the display 201, like other region of the screen display region 201A, and additionally obtaining the user's biometric information (e.g., a fingerprint). According to an embodiment, the sensing region 201B also may be formed in the key input device 217.

According to an embodiment, the display 201 may include a region in which a first camera 205 (e.g., the camera module 180 of FIG. 1) is positioned. According to an embodiment, an opening is formed in the region of the display 201, and the first camera 205 (e.g., a punch hole camera) may be at least partially disposed in the opening to face the front surface 200A. In this case, the screen display region 201A may surround at least a portion of a periphery part of the opening. According to an embodiment, the first camera 205 (e.g., an under display camera (UDC)) may be disposed under the display 201 to overlap with the region of the display 201. In this case, the display 201 may provide the visual information to the user through the region, and additionally, the first camera 205 may obtain an image corresponded to a direction toward the front surface 200A through the region of the display 201.

According to an embodiment, the display 201 may be combined with or disposed adjacent to a touch sensing circuit, a pressure sensor capable of measuring the strength (pressure) of the touch, and/or a digitizer that detects a magnetic field-type stylus pen.

According to an embodiment, the audio module 203, 204, and 207 (e.g., the audio module 170 of FIG. 1) may include a microphone hole 203 and 204 and a speaker hole 207.

According to an embodiment, the microphone hole 203 and 204 may include a first microphone hole 203 formed in a partial region of the side surface 200C and a second microphone hole 204 formed in a partial region of the rear surface 200B. The microphone (not illustrated) for obtaining an external sound may be disposed inside the microphone hole 203 and 204. The microphone may include a plurality of microphone to detect a direction of sound.

According to an embodiment, the second microphone hole 204 formed in the partial region of the rear surface 200B may be disposed adjacent to the camera module 205, 212, and 213. For example, the second microphone hole 204 may obtain sound according to an operation of the camera module 205, 212, and 213. However, it is not limited thereto.

According to an embodiment, the speaker hole 207 may include an external speaker hole 207 and a call receiver hole (not illustrated). The external speaker hole 207 may be formed on the portion of the side surface 200C of the electronic device 101. According to an embodiment, the external speaker hole 207 may be implemented as one hole with the microphone hole 203. Although not illustrated, the call receiver hole (not illustrated) may be formed on another portion of the side surface 200C. For example, the call receiver hole may be formed on a opposite side of the external speaker hole 207 on the side surface 200C. For example, based on illustration of FIG. 2A, the external speaker hole 207 may be formed on the side surface 200C corresponding to a lower end of the electronic device 101, and the call receiver hole may be formed on the side surface 200C corresponding to an upper end of the electronic device 101. However, it is not limited thereto, and according to an embodiment, the call receiver hole may be formed at a position other than the side surface 200C. For example, the call receiver hole may be formed by a spaced space between the front plate 202 (or the display 201) and the frame 218.

According to an embodiment, the electronic device 101 may include at least one speaker (not illustrated) configured to output sound to an outside of a housing through the external speaker hole 207 and/or the call receiver hole (not illustrated).

According to an embodiment, the sensor module (not illustrated) (e.g., the sensor module 176 of FIG. 1) may generate an electrical signal or a data value corresponding to an internal operating state or an external environmental state of the electronic device 101. For example, the sensor module may include at least one of a proximity sensor, a heart rate monitor (HRM) sensor, a fingerprint sensor, a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor.

According to an embodiment, the camera module 205, 212, and 213 (e.g., the camera module 180 of FIG. 1), may include the first camera 205 disposed to face the front surface 200A of the electronic device 101, the second camera 212 disposed to face the rear surface 200B of the electronic device 101, and a flash 213.

According to an embodiment, the second camera 212 may include a plurality of cameras (e.g., a dual camera, a triple camera, or a quad camera). However, the second camera 212 is not necessarily limited to including the plurality of cameras, and also may include one camera.

According to an embodiment, the first camera 205 and the second camera 212 may include one or more lenses, an image sensor, and/or an image signal processor.

According to an embodiment, for example, the flash 213 may include a light emitting diode or a xenon lamp. According to an embodiment, two or more lenses (an infrared camera, a wide-angle and telephoto lens), and image sensors may be disposed on a surface of the electronic device 101.

According to an embodiment, the key input device 217 (e.g., the input module 150 of FIG. 1) may be disposed on the side surface 200C of the electronic device 101. According to an embodiment, the electronic device 101 may not include a portion or all of the key input device 217, and the key input device 217 that is not included may be implemented in another form such as a soft key on the display 201.

According to an embodiment, the connector hole 208 may be formed on the side surface 200C of the electronic device 101 so that a connector of an external device may be accommodated. A connection terminal (e.g., the connection terminal 178 of FIG. 1) electrically connected to the connector of the external device may be disposed in the connector hole 208. The electronic device 101 according to an embodiment may include an interface module (e.g., the interface 177 of FIG. 1) for processing an electrical signal transmitted and received through the connection terminal.

According to an embodiment, the electronic device 101 may include the light emitting element (not illustrated). For example, the light emitting element (not illustrated) may be disposed on the front surface 200A of the housing. The light emitting element (not illustrated) may provide state information of the electronic device 101 in an optical form. According to an embodiment, the light emitting element (not illustrated) may provide a light source linked with an operation of the first camera 205. For example, the light emitting element (not illustrated) may include a light emitting diode (LED), an IR LED, and/or the xenon lamp.

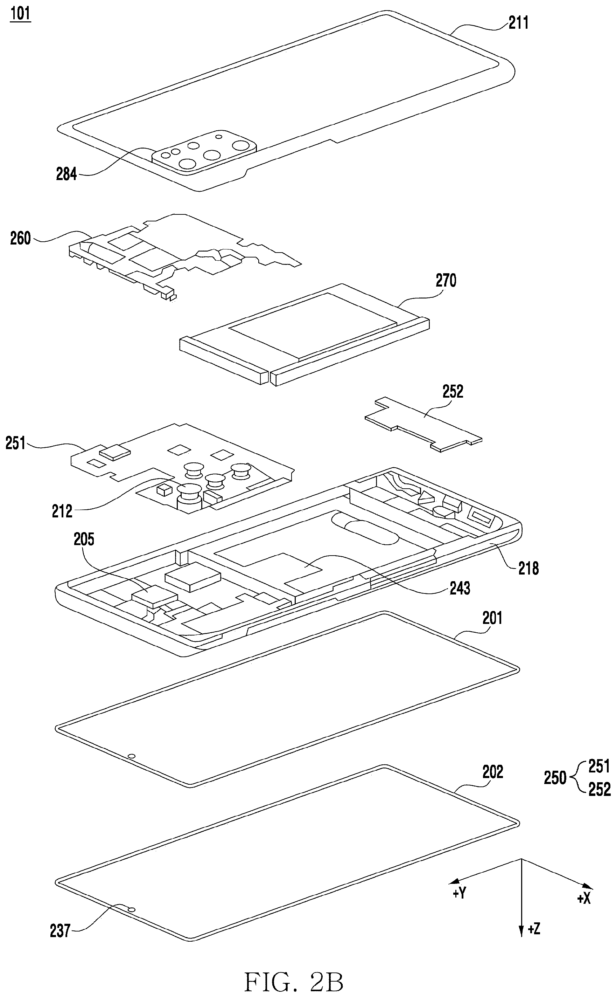

FIG. 2B is an exploded perspective view of an electronic device according to an embodiment.

Hereinafter, an overlapping description of the configuration having the same reference code as the above-described configuration will be omitted.

Referring to FIG. 2B, the electronic device 101 according to an embodiment may include the frame 218, a bracket 243, a printed circuit board 250, a cover plate 260, and/or a battery 270. The printed circuit board 250 may include a first printed circuit board 251 which is a main board and a second printed circuit board 252 which is a sub-board.

According to an embodiment, the electronic device 101 may the frame 218 forming an exterior (e.g., the side surface 200C of FIG. 2A) of the electronic device 101 and the bracket 243 extended inward from the frame 218. According to an embodiment, the frame 218 and the bracket 243 may be disposed between the display 201 and the rear plate 211. For example, the frame 218 may surround a space between the rear plate 211 and the front plate 202 (and/or the display 201). For example, the bracket 243 may be extended from the frame 218 within the space.

According to an embodiment, the bracket 243 may support or accommodate other components included in the electronic device 101. For example, the display 201 may be disposed on a surface of the bracket 243 facing in a direction (e.g., +z direction), and the display 201 may be supported by a support portion of the bracket 243. For example, the first printed circuit board 251, the second printed circuit board 252, the battery 270, and a second camera module 212 may be disposed on another surface facing a direction (e.g., -z direction) opposite to the direction. For example, the first printed circuit board 251, the second printed circuit board 252, the battery 270, and the second camera module 212 may be respectively seated in a recess defined by frame 218 and/or the bracket 243.

According to an embodiment, the first printed circuit board 251, the second printed circuit board 252, and the battery 270 may be coupled to the bracket 243, respectively. For example, the first printed circuit board 251 and the second printed circuit board 252 may be fixedly disposed in the bracket 243 through a coupling member such as a screw. For example, the battery 270 may be fixedly disposed in the bracket 243 through an adhesive member (e.g., a double-sided tape). However, it is not limited by the above-described example.

According to an embodiment, the cover plate 260 may be disposed between the first printed circuit board 251 and the rear plate 211. According to an embodiment, the cover plate 260 may be disposed on the first printed circuit board 251. For example, the cover plate 260 may be disposed on a surface of the first printed circuit board 251 facing the -z direction.

According to an embodiment, the cover plate 260 may at least partially overlap the first printed circuit board 251 based on a z-axis. According to an embodiment, the cover plate 260 may cover at least a partial region of the first printed circuit board 251. Through this, the cover plate 260 may protect the first printed circuit board 251 from a physical impact or prevent a connector coupled to the first printed circuit board 251.

According to an embodiment, the cover plate 260 may be fixedly disposed in the first printed circuit board 251 through a coupling member (e.g., the screw), or may be coupled to the bracket 243 together with the first printed circuit board 251 through the coupling member.

According to an embodiment, the display 201 may be disposed between the bracket 243 and the front plate 202. For example, the front plate 202 may be disposed on a side (e.g., +z direction) of the display 201, and the bracket 243 may be disposed on another side (e.g., -z direction).

According to an embodiment, the front plate 202 may be coupled to the display 201. For example, the front plate 202 and the display 201 may be adhered to each other through an optical adhesive member (e.g., an optically clear adhesive (OCA) or an optically clear resin (OCR)) interposed therebetween.

According to an embodiment, the front plate 202 may be coupled to the frame 218. For example, the front plate 202 may include an outer portion extended outside the display 201 when viewed in a z-axis direction, and may be adhered to the frame 218 through an adhesive member (e.g., a waterproof tape) disposed between the outer portion of the front plate 202 and the frame 218. However, it is not limited by the above-described example.

According to an embodiment, a processor (e.g., the processor 120 of FIG. 1), memory (e.g., the memory 130 of FIG. 1), and/or an interface (e.g., the interface 177 of FIG. 1) may be disposed on the first printed circuit board 251 and/or the second printed circuit board 252. For example, the processor may include one or more of a central processing unit, an application processor, a graphics processing unit, an image signal processor, a sensor hub processor, or a communication processor. For example, the memory may include volatile memory (e.g., the volatile memory 132 of FIG. 1) or nonvolatile memory (e.g., the nonvolatile memory 134 of FIG. 1). For example, the interface may include a high definition multimedia interface (HDMI), a universal serial bus (USB) interface, a secure digital (SD) card interface, and/or an audio interface. The interface may electrically or physically connect the electronic device 101 to an external electronic device, and may include a USB connector, an SD card/multimedia card (MMC) connector, or an audio connector. According to an embodiment, the first printed circuit board 251 and the second printed circuit board 252 may be operatively or electrically connected to each other through a connection member (e.g., a flexible printed circuit board).

According to an embodiment, the battery 270 (e.g., the battery 189 of FIG. 1) may supply power to at least one component of the electronic device 101. For example, the battery 270 may include a rechargeable secondary battery or a fuel cell. At least a portion of the battery 270 may be disposed substantially on the same plane as the first printed circuit board 251 and/or the second printed circuit board 252.

The electronic device 101 according to an embodiment may include an antenna module (not illustrated) (e.g., the antenna module 197 of FIG. 1). According to an embodiment, the antenna module may be disposed between the rear plate 211 and the battery 270. For example, the antenna module may include a near field communication (NFC) antenna, a wireless charging antenna, and/or a magnetic secure transmission (MST) antenna. For example, the antenna module may perform short-range communication with the external device or wirelessly transmit and receive power with the external device.

According to an embodiment, the first camera 205 (e.g., a front camera) may be disposed in at least a portion of the bracket 243 so that the lens may receive external light through a partial region (e.g., a camera region 237) of the front plate 202 (e.g., the front surface 200A of FIG. 2A).

According to an embodiment, the second camera module 212 (e.g., a rear camera) may be disposed between the bracket 243 and the rear plate 211. According to an embodiment, the second camera module 212 may be electrically connected to the first printed circuit board 251 through the connection member (e.g., the connector). According to an embodiment, the second camera module 212 may be disposed so that the lens may receive the external light through a camera region 284 of the rear plate 211 of the electronic device 101.

According to an embodiment, the camera region 284 may be formed on a surface (e.g., the rear surface 200B of FIG. 2A) of the rear plate 211. According to an embodiment, the camera region 284 may be at least partially transparently formed so that the external light may be incident on the lens of the second camera module 212. According to an embodiment, at least a portion of the camera region 284 may protrude from the surface of the rear plate 211 to a predetermined height. However, it is not limited thereto, and according to an embodiment, the camera region 284 may form substantially the same plane as the surface of the rear plate 211.

According to an embodiment, the housing assembly 210 of the electronic device 101 may mean the configuration or the structure forming at least a portion of the exterior of the electronic device 101. In this respect, at least a portion of the front plate 202, the frame 218, the bracket 243, and/or the rear plate 211 forming the exterior of the electronic device 101 may be referred to as the housing assembly 210 of the electronic device 101.

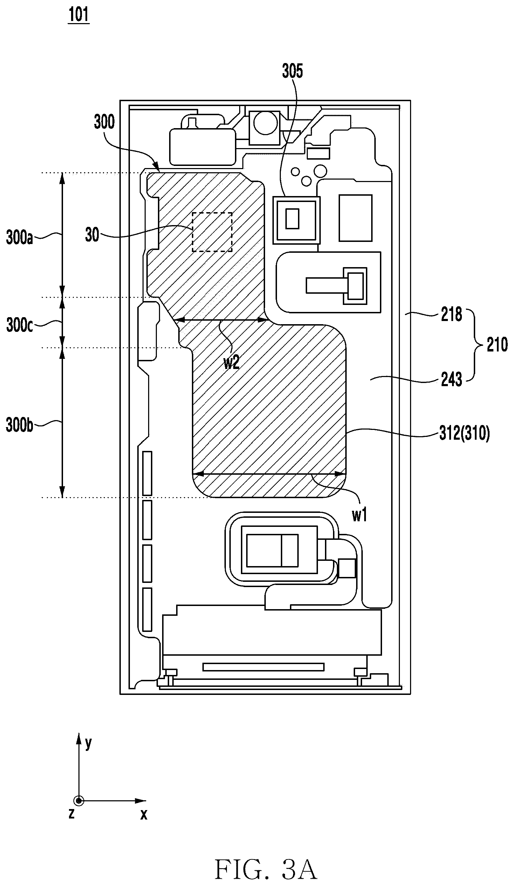

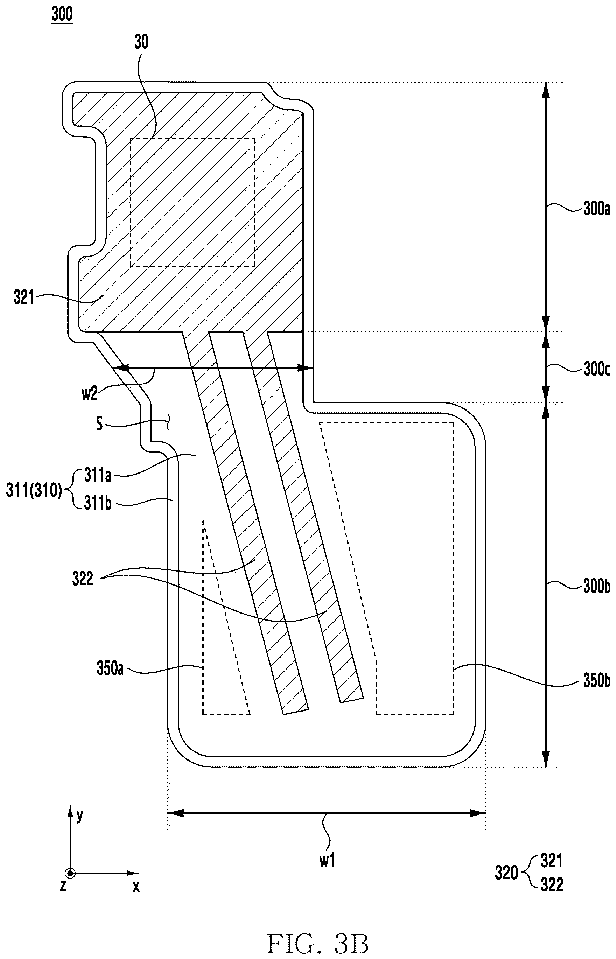

FIG. 3A illustrates a portion of an exemplary electronic device. FIG. 3B illustrates a portion of a vapor chamber of an exemplary electronic device.

Referring to FIG 3A and FIG. 3B, an electronic device 101 may include an electronic component 30 (or a heat emitting component) and a vapor chamber 300. The vapor chamber 300 may include an enclosure 310 defining a space S for a fluid (hereafter, the fluid may also be referred to as a substance or cooling substance), the enclosure being positioned at least partially on or over the electronic component 30, and a wick structure 320 disposed within the space S (hereafter, the wick structure 320 may also be referred to as a transport medium or a fluid transfer element). It will be understood that, when referring to the enclosure 310 being on or over the electronic component 30, this may understood to mean that these components are arranged relative to one another such that, when viewed from above (or a specific direction), the enclosure 310 would block view of the electronic component 30 (or at least a covered portion thereof).

According to an embodiment, the vapor chamber 300 may be configured to receive at least a portion of heat emitted from the electronic component 30. For example, the vapor chamber 300 and the electronic component 30 may be disposed within the electronic device 101. For example, the vapor chamber 300 may be surrounded by a frame 218 forming at least a portion of a side surface (e.g., the side surface 200C of FIG. 2A) of the electronic device 101. For example, the vapor chamber 300 may be positioned around the electronic component 30 to receive heat emitted from the electronic component 30. For example, at least a portion of the vapor chamber 300 may at least partially overlap the electronic component 30 when viewing the electronic component 30 from above (e.g., when viewed in a +z direction). For example, at least the portion of the vapor chamber 300 may face the electronic component 30. For example, at least the portion of the vapor chamber 300 may be in contact with the electronic component 30.

For example, the electronic component 30 may be mounted on a printed circuit board (e.g., the first printed circuit board 251 or the second printed circuit board 252 of FIG. 2B) in the electronic device 101. At least the portion of the vapor chamber 300 may face at least a portion of the printed circuit board on which the electronic component 30 is disposed. For example, the vapor chamber 300 may be seated on a bracket 243 in a housing assembly 210 of the electronic device 101 facing the printed circuit board to receive at least a portion of heat generated from the electronic component 30 disposed on the printed circuit board (e.g., the first printed circuit board 251 or the second printed circuit board 252). For example, the vapor chamber 300 may be disposed on a surface of the bracket 243 facing the display of the housing assembly 210 (e.g., the display 201 of FIG. 2A). For example, at least the portion of the bracket 243 may be disposed between the electronic component 30 and the vapor chamber 300. The vapor chamber 300 may be configured to receive at least a portion of the heat generated from the electronic component 30 through the bracket 243. At least a portion disposed between the electronic component 30 and the vapor chamber 300 in the bracket 243 may include metal, but is not limited thereto.

For example, the electronic component 30 may be a processor (e.g., the processor 120 of FIG. 1) of the electronic device 101 with a relatively high amount of heat generated. For example, the electronic component 30 may be disposed on a surface of the printed circuit board (e.g., the first printed circuit board 251 or the second printed circuit board 252 of FIG. 2B) facing the vapor chamber 300. The electronic component 30 may perform data processing or a calculation according to the operation of the electronic device 101. The electronic component 30 may emit heat by performing the data processing or the calculation. By receiving at least a portion of the heat emitted from the electronic component 30, the vapor chamber 300 may reduce damage to the electronic component 30 and/or at least one other electronic component around the electronic component 30 due to the heat. The electronic component 30 may be referred to as a heat generating component or a heat generating body of the electronic device 101 in that it is an element that generates heat, but is not limited thereto.

According to an embodiment, the enclosure 310 may include a first plate 311 and a second plate 312 coupled on the first plate 311 to seal the space S for the fluid of the enclosure 310. The fluid within the space S may be referred to as a cooling material (or a refrigeration material, or thermal transfer substance) in terms of being configured to cool, or otherwise change a temperature of, the electronic component 30 through a phase change. For example, the enclosure 310 may form an exterior of the vapor chamber 300. The enclosure 310 may include a metal having a relatively high thermal conductivity, but is not limited thereto. For example, the first plate 311 may be a plate supported or attached by the housing assembly 210 (or the bracket 243) of the electronic device 101. The first plate 311 may be the plate that receives heat from the electronic component 30. For example, the second plate 312 may be disposed on the first plate 311. The second plate 312 may be a plate facing a display 201 of the electronic device 101. For example, the second plate 312 may be fastened on the first plate 311. The second plate 312 may provide the space S for the fluid of the vapor chamber 300 together with the first plate 311. For example, the second plate 312 may define regions 300a, 300b, and 300c of the vapor chamber 300 and/or the enclosure 310 together with the first plate 311. For example, the second plate 312 may have a shape overlapping the first plate 311 when viewed the vapor chamber 300 from above (e.g., when viewed from +z direction), but is not limited thereto.

For example, the first plate 311 may include a base 311a for supporting the wick structure 320 and a sidewall 311b that is disposed along a periphery of the base 311a and protrudes from the base 311a to be coupled to the second plate 312. The sidewall 311b may be configured to form the space S between the base 311a and the second plate 312 or surround the space S by supporting the second plate 312. A height of the space S of the enclosure 310 may be provided by the sidewall 311b. However, the above-described embodiment is exemplary, and for example, the sidewall 311b providing the height to the space S may extend from the second plate 312 toward the first plate 311. For example, the sidewall 311b may instead be considered to be part of the second plate 312, or may be considered separate to the first plate 311 and the second plate 312.

According to an embodiment, the enclosure 310 may include a first region 300a (or first portion) disposed at least partially over the electronic component 30 to receive heat emitted from the electronic component 30, a second region 300b (or second portion) spaced apart from the first region 300a, and a third region 300c (or third portion) connecting the first region 300a and the second region 300b. The third region 300c may have smaller internal volume than the second region 300b. For example, the vapor chamber 300 and/or the enclosure 310 may define or form the regions 300a, 300b, and 300c. For example, the vapor chamber 300 may include the fluid within the space S of the enclosure 310 to disperse the heat transferred from the electronic component 30 to the vapor chamber 300. The fluid may be vaporizable by the heat transferred from the electronic component 30 to the vapor chamber 300. The fluid may be liquefiable as the heat is emitted from the vapor chamber 300. For example, the fluid may be water, but is not limited thereto. For example, the regions 300a, 300b, and 300c may diffuse the heat emitted from electronic components 30 or from the space S for cooling the electronic components 30 by using a phase change of the fluid in the vapor chamber 300.

For example, the first region 300a may be a region at least partially overlapping the electronic component 30 when viewing the vapor chamber 300 from above (e.g., viewed from +z direction). The first region 300a may be the region that receives the heat from the electronic component 30. For example, the first region 300a may receive more heat than the second or third regions 300b, 300c. For example, the first region 300a may be a region facing the electronic component 30 or contacting the electronic component 30. For example, the first region 300a may be faced away from the electronic component 30. For example, the first region 300a may be a region spaced apart from the electronic component 30 by an internal structure (e.g., the bracket 243) of the electronic device 101. For example, at least the portion of a fluid of a liquid state in the first region 300a may be vaporized by the heat transferred from the electronic component 30 to the first region 300a. The first region 300a may be configured to diffuse the heat emitted from the electronic component 30 through the third region 300c and the second region 300b or to cool the electronic component 30 by vaporizing the fluid of the liquid state in the first region 300a. The first region 300a may be referred to as an evaporation port and/or a heat source of the vapor chamber 300 in that the fluid of the liquid state within the space S of the enclosure 310 is vaporized by the heat emitted from the electronic component 30, but is not limited thereto.

For example, the second region 300b may be the region configured to have a lower temperature than the first region 300a that receives the heat from the electronic component 30 by being spaced apart from the first region 300a (or by being spaced apart from the electronic component 30). For example, the second region 300b may be a region in which the fluid of/in a gaseous state - which is moved from the first region 300a, through the third region 300c, to the second region 300b - emits heat. By emitting heat (i.e. from the fluid in the gaseous state), the temperature of the second region 300b reduces to be lower than the temperature of the first region 300a. The fluid of the gaseous state in the second region 300b may be liquefied by emitting the heat to an outside of the vapor chamber 300 in the second region 300b. For example, the fluid of the gaseous state in the second region 300b heats up the walls of the second region 300b (i.e. the part of enclosure 310 corresponding to the second region 300b) resulting in the fluid being liquified in the second region 300b through the walls of the second region 300b emitting heat to outside of the vapor chamber 300. The second region 300b may be referred to as a condensation portion of the vapor chamber 300 in that it is the region in which the fluid of/in the gaseous state within the space S of the enclosure 310 is liquefied or condensed, but is not limited thereto.

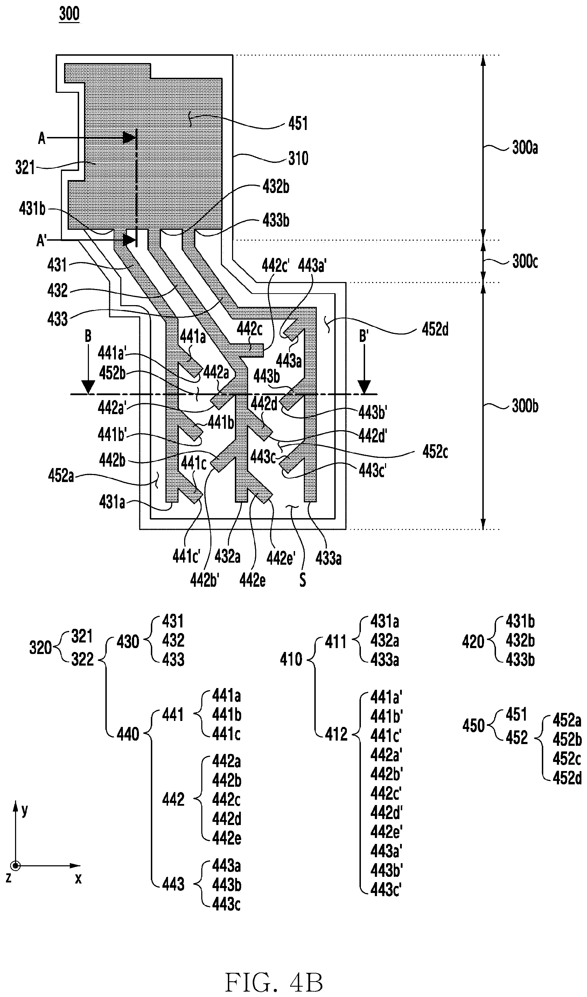

For example, the third region 300c may be a region that provides a path for the fluid movement between the first region 300a and the second region 300b. The third region 300c may be disposed between the first region 300a and the second region 300b. For example, the third region 300c may extend from the first region 300a to the second region 300b. For example, by connecting an internal space of the first region 300a and an internal space of the third region 300b, the third region 300c may provide a passage (e.g., a second channels 452 of FIG. 4B) for the fluid of the gaseous state to move from the first region 300a to the second region 300b or a passage through which the wick structure 320 passes such that the fluid of the liquid state can move from the second region 300b to the first region 300a through the wick structure 320. The third region 300c may be referred to as a neck portion or joining portion of the vapor chamber 300 in that it is the region connecting the first region 300a and the second region 300b, but is not limited thereto.

For example, an internal volume of the third region 300c may be smaller than an internal volume of the second region 300b. In other words, the third region 300c may define a volume of space within the vapor chamber 300 that is smaller than the volume of space defined by the second region 300b. For example, the electronic device 101 may require a structure in which the first region 300a and the third region 300b of the vapor chamber 300 disposed on the bracket 243 are tilted with respect to each other and/or a size of the third region 300c is relatively small, by internal components (or the structure) of the electronic device 101 mounted on the bracket 243 of the housing assembly 210. For example, the first region 300a may be disposed to be inclined in a direction parallel to an x-axis with respect to the second region 300b by one or more cameras 305 mounted on the bracket 243. For example, the first region 300a may be offset based on a y-axis with respect to the second region 300b by one or more cameras 305 disposed around the first region 300a. For example, a center point of the first region 300a may be offset from a center point of the second region 300b by one or more cameras 305 when viewing the vapor chamber 300 from above (e.g., when viewed from +z direction). For example, a virtual line connecting the center point of the first region 300a and the center point of the second region 300b may not be parallel to the x-axis. For example, the third region 300c may have smaller size than the first region 300a and/or the second region 300b to connect the first region 300a and the second region 300b by one or more cameras 305. For example, due to one or more cameras 305 being disposed with respect to a preset width of the frame 218 of the electronic device 101 and/or due to a disposition of the one or more cameras 305 within the electronic device 101, a width w2 of the third region 300c may be smaller than a width w1 of the second region 300b. However, it is not limited thereto, and the enclosure 310 may include the third region 300c formed to hinder movement of the fluid in the enclosure 310 by including an irregular shape in which the first region 300a is offset with respect to the second region 300b. The third region 300c may be referred to as a bottle neck section of the enclosure 310, but is not limited thereto.

According to an embodiment, the wick structure 320 may include a first portion 321 disposed in the first region 300a and a second portion 322 extending from the first portion 321, across the third region 300c, to the second region 300b. For example, the wick structure 320 may be covered or surrounded by the enclosure 310. The wick structure 320 may be disposed between the first plate 311 and the second plate 312 of the enclosure 310. For example, the wick structure 320 may include a porous structure and/or a capillary structure for absorbing the fluid of the liquid state in the vapor chamber 300. For example, the wick structure 320 may include at least one of a mesh wick, and a sintering wick for absorbing the fluid of the liquid state, but is not limited thereto.

For example, the first portion 321 may be a portion of the wick structure 320 that overlaps the first region 300a when viewed the vaper chamber 300 from above. The first portion 321 may be attached to the first plate 311 within the space S defined by the enclosure 310. The first portion 321 may be spaced apart from the second plate 312 by being attached on the base 311a of the first plate 311 in the first region 300a. A flow path (e.g., the first channel 451 of FIG. 4B) for the fluid of the gaseous state may be formed on the first portion 321 by a height of the sidewall 311b of the first plate 311. The fluid of the liquid state in the first portion 321 may be moved to the flow path for the fluid of the gaseous state between the first portion 321 and the second plate 312 by being vaporized by the heat emitted from the electronic component 30 to. In other words, the flow path may correspond to the space in the first region 300a or enclosure 310 above or around the first portion 321, into which the fluid is vaporized or evaporated so as to be in gaseous form.

For example, the second portion 322 may be a portion of the wick structure 320 disposed in or across the second region 300b and the third region 300c. For example, the second portion 322 may contact the first plate 311 and the second plate 312 in the second region 300b and the third region 300c. The second portion 322 may form or define a flow path (e.g., the second channels 452 of FIG. 4B) for the fluid of the gaseous state between the second portion 322 and/or the enclosure 310 by extending from the first plate 311 to the second plate 312. In other words, the flow path may correspond to the space in the second region 300b, the third region 300c, and/or enclosure 310 above or around the second portion 322, in which the fluid in the gaseous state can move. The second portion 322 may penetrate the third region 300c, in order to move the fluid of the liquid state from the second region 300b to the first portion 321 in the first region 300a through the third region 300c.

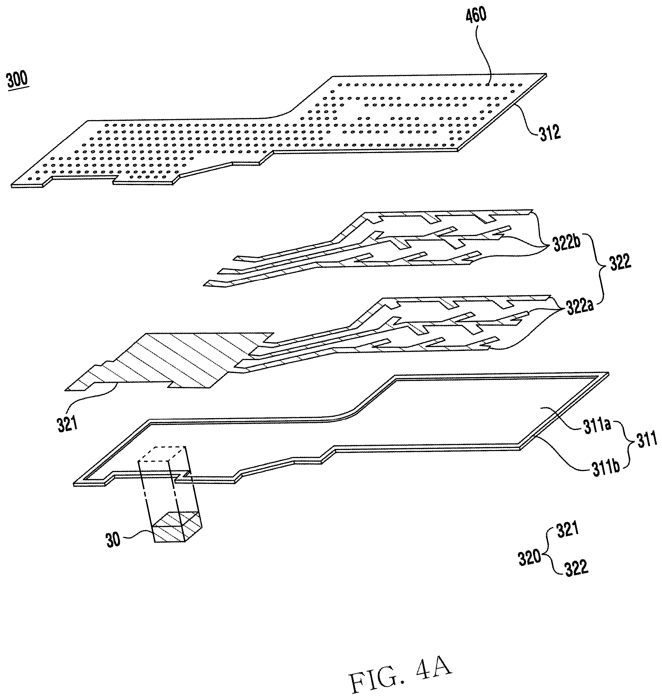

Since the second portion 322 of the wick structure 320 penetrate the third region 300c with a relatively small width w2 by the internal structure and/or components (e.g., one or more cameras 305) of the electronic device 101, an absorption rate of the fluid of the liquid state in the second region 300b may decrease. For example, the second region 300b may be disposed to be inclined in a direction parallel to the y-axis with respect to the first region 300a due to one or more cameras 305 (e.g. due to the position of the one or more cameras 305 in the electronic device 101 relative to the vapor chamber 300). The third region 300c may have smaller internal volume than the second region 300b to connect the first region 300a and the second region 300b by the one or more cameras 305. For example, since the width w2 of the third region 300c is configured to be smaller than the width w1 of the second region 300b, the absorption rate of the fluid of the liquid state in the second region 300b of the second portion 322 extending across the third region 300c to the second region 300b may decrease. For example, since there is an increase in a volume of extra regions 350a and 350b in the second region 300b in which the second portion 322 is not disposed, due to the third region 300c having a relatively smaller internal volume, the absorption rate of the fluid of the liquid state in the second region 300b absorbed by the second portion 322 may decrease. The vapor chamber 300 may require the wick structure 320 for improving performance of the vapor chamber 300 by increasing the absorption rate of the fluid of the liquid state in the second region 300b. The structure of the second portion 322 for improving the performance of the vapor chamber 300 is described and illustrated through FIG. 4A and FIG. 4B.

FIG. 4A is an exploded perspective view of a vapor chamber of an exemplary electronic device. FIG. 4B illustrates a portion of a vapor chamber of an exemplary electronic device.

Referring to FIGS. 4A and 4B, an electronic device (e.g., the electronic device 101 of FIG. 1) may include an electronic component 30 and a vapor chamber 300. The vapor chamber 300 may include an enclosure 310 defining a space S for a fluid on the electronic component 30 and a wick structure 320 disposed within the space S. The enclosure 310 may include a first region 300a disposed at least partially over the electronic component 30 to receive heat emitted from the electronic component 30, a second region 300b spaced apart from the first region 300a, and a third region 300c connecting the first region 300a and the second region 300b and having smaller internal volume than the second region 300b. For example, the third region 300c may form a bottleneck between the first region 300a and the second region 300b, the third region 300c having a cross-section which is smaller in at least one dimension (e.g. along the x-axis shown in FIG. 4B) than that of a corresponding cross-section of the second region 300b. The wick structure may include a first portion 321 disposed in the first region 300a, and a second portion 322 extending from the first portion 321, across the third region 300c, to the second region 300b. According to an embodiment, the enclosure 310 may include a first plate 311 and a second plate 312 coupled on the first plate 311 to seal the space S. It will be appreciated that a description of a feature of Figures 3A or 3B may be applied to a like feature of Figures 4A or 4B, bearing in mind that Figures 4A and 4B also describe new features and/or modified features to those of Figures 3A and 3B. However, the description of Figures 3A and 3B should not be seen to limit the examples of Figures 4A and 4B or imply restrictions on the examples of Figures 4A and 4B.

According to an embodiment, a number (e.g. a counted number or predetermined number) of first end portions 410 of the second portion 322 disposed in the second region 300b may be greater than a number (e.g. a counted number or predetermined number) of second end portions 420 of the second portion 322 connected to the first portion 321 disposed in the first region 300b to absorb the fluid in the second region 300b. Herein, first end portions 410 may also be termed first extensions. Herein, second end portions 420 may also be termed second extensions. According to an example, one or more second end portions 420 are provided and a greater number of first end portions 410 are provided.

For example, the second portion 322 may extend from the second end portions 420, across the third region 300b, to the first end portions 410 in the second region 300b. For example, the first end portions 410 may be end portions configured to absorb a fluid of/in a liquid state in the second region 300b among the end portions of the second portion 322. The first end portions 410 may increase a surface area of the second portion 322 for absorbing the fluid of the liquid state in the second region 300b. For example, the second end portions 420 may be a portion in which the fluid of the liquid state moves from the second portion 322 to the first portion 321, or the fluid of the liquid state moves from the first portion 321 to the second portion 322. For example, among the end portions of the second portion 322, the second end portions 420 may be the portion contacted the first portion 321 or adjacent to the first portion 321. For example, the second end portions 420 may be positioned at a boundary between the first region 300a and the third region 300c, but are not limited thereto. As the number of the first end portions 410 positioned in the second region 300b is configured to be larger than the number of the second end portions 420 connected to the first portion 321, the second portion 322 of the wick structure 320 may increase the absorption rate of the fluid of the liquid state in the second region 300b for moving the fluid of the liquid state in the second region 300b through the third region 300c having a relatively small internal volume.

According to an embodiment, the second portion 322 may include one or more stem portions 430 defining the second end portions 420 by extending from the first portion 321, across the third region 300c, to the second region 300b. The second portion 322 may include a plurality of branch portions 440 (or sub-portions) defining at least the portion of the first end portions 410 by branching from each of the one or more stem portions 430 in the second region 300b. That is, each branch portion 440 extends from one of the stem portion(s) 430 in the second region 300b.

For example, one or more stem portions 430 may provide a flow path for the fluid of the liquid state to move from the second region 300b to the first portion 321, by extending from the first portion 321 to the second region 300b through the third region 300c. For example, the one or more stem portions 430 may be a region including second the end portions 420 among the second portions 322. The one or more stem portions 430 may be a portion penetrating the third region 300c having the relatively small internal volume, by extending from the second end portions 420. For example, one or more stem portions 430 may include the plurality of stem portions 431, 432, and 433. Each of the plurality of stem portions 431, 432, and 433 may provide the flow paths for the fluid of the liquid state extending from the first portion 421, across the third region 300c, to the second region 300b. Each of the plurality of stem portions 431, 432, and 433 may include end portions 431b, 432b, and 433b connected to the first portion 421. The end portions 431b, 432b and 433b may correspond to the second end portions 420 of the second portion 322 to which the second portion 322 and the first portion 321 are connected. The counted number of the second end portions 420 may correspond to a counted number of the one or more stem portions 430 and/or a counted number of end portions 431b, 432b, and 433b of the one or more stem portions 430 to which the one or more stem portions 430 and the first portion321 are connected, but is not limited thereto.

For example, the plurality of the branch portions 440 may extend from one or more stem portions 430 portions positioned within the second region 300b. The plurality of the branch portions 440 may provide additional end portions or extensions/protrusions to the second portion 322 for absorbing the fluid of the liquid state in the second region 300b by branching from one or more stem portions 430 in the second region 300b, respectively. For example, one or more stem portions 430 may include the plurality of stem portions 431, 432, and 433. The plurality of the branch portions 440 may provide the first end portions 410 of the second portion 322 in the second region 300b together with the plurality of the stem portions 431, 432, and 433, by extending from each of the plurality of stem portions 431, 432, and 433 in the second region 300b. Since the plurality of the branch portions 440 provide the additional end portions of the second portion 322 disposed in the second region 300b in addition to the end portions provided by the plurality of stem portions 431, 432, and 433, the counted number of the first end portions 410 of the second portion 322 disposed in the second region 300b may be greater than the counted number of the second end portions 420 of the second portion 321 connected to the first portion 321. Since the counted number of the first end portions 410 is greater than the counted number of the second end portions 420, the second portion 322 may increase the absorption rate of the fluid of the liquid state in the second region 300b. For example, the greater number of first end portions 410 means there may be fewer or smaller extra regions in the second region 300b in which the second portion 322 is not disposed.

For example, the first end portions 410 may include a third end portions 411 defined by the one or more stem portions 430 and a fourth end portions 412 defined by the plurality of the branch portions 440. The plurality of the branch portions 440 may extend from each portions of the one or more stem portions 430 connecting the second end portions 420 and the third end portions 411 defined by the one or more stem portions 430. For example, the one or more stem portions 430 may include the plurality of stem portions 431, 432, and 433. Among the first end portions 410, the third end portions 411 may correspond to end portions 431a, 432a, and 433a disposed in the second region 300b of each of the plurality of stem portions 431, 432, and 433. The second end portions 420 may correspond to other end portions 431b, 432b and 433b of each of the plurality of stem portions 431, 432, and 433.

For example, among the first end portions 410, the fourth end portions 412 may be the additional end portions defined by the plurality of the branch portions 440 in the second region 300b. For example, the plurality of the branch portions 440 may include a first set of branch portions 441 branching from a first stem portion 431, a second set of branch portions 442 branching from a second stem portion 432, and a third set of branch portions 443 branching from a third stem portion 433. The first set of the branch portions 441 may include end portions 441a', 441b', and 441c' defined by each of the branch portions 441a, 441b, and 441c included in the first set of the branch portions 441. The second set of the branch portions 442 may include end portions 442a', 442b, 442c, 442d, and 442e defined by each of the branch portions 442a, 442b', 442c', 442d', and 442e' included in the second set of the branch portions 442. The third set of the branch portions 443 may include end portions 443a', 443b', and 443c' defined by each of the branch portions 443a, 443b, and 443c included in the third set of the branch portions 443. Since the counted number of the second end portions 420 of the second portion 322 corresponds to the counted number of the third end portions 411 defined by each of the plurality of the stem portions 430, and the first end portions 410 include the additional end portions 441a', 441b', 441c', 442a', 442b', 442c', 442d', 442e', 443a', 443b', and 443b' provided by the plurality of the branch portions 440 in addition to the third ends 411, the second portion 322 may increase the absorption rate of the fluid of the liquid state in the second region 300b through the plurality of branch portions 440 and/or the additional end portions 441a', 441b', 441c', 442b', 442c', 442d', 442e', 443a', 443a', 443b', 443b', and 443c'.

For example, the first set of the branch portions 441 may extend from a side portion of the first stem portion 431 between both ends 431a and 431b of the first stem portion 431, respectively. The second set of the branch portions 442 may extend from the side portion of the second stem portion 432 between both ends 432a and 432b of the second stem portion 432, respectively. The third set of the branch portions 443 may extend from the side portion of the third stem portion 433 between both ends 433a and 433b of the third stem portion 433, respectively. By extending from the side portion of one or more stem portions 430, each of the plurality of branch portions 440 may reduce a length of each of second channels 452 (or the flow path(s)) for a fluid of/in a gaseous state and increase the absorption rate of the fluid of/in the liquid state.

For example, the first set of the branch portions 441 may be disposed to face the branch portions 442a, 442b of the second set of the branch portions 442. Each of the end portions 441a', 441b', 441c' defined by each of the branch portions 441 of the first set may be spaced apart from the end portions 442a', 442b' defined by each of the branch portions 442a, 442b for a channel 452b between the first stem portion 431 and the second stem portion 432. For example, among the second set of the branch portions 442, the branch portions 442c, 442d, 442e may be disposed to face the third set of the branch portions 443. The end portions 442c', 442d', 442e' defined by each of the branch portions 442c, 442d, 442e may be spaced apart from the end portions 443a', 443b', 443c' defined by each of the third set of the branch portions 443 for a channel 452c between the second stem portion 432 and the third stem portion 433. The first end portions 410 of the second portion 322 in the second region 300b may provide the second channels 452 for the fluid of/in the gaseous state by being spaced apart from each other.

According to an embodiment, the second portion 322 of the wick structure 320 may have a leaf-vein fractal shape by the first end portions 410 in the second region 300b. However, the above-described embodiment is exemplary, and a structure of the second portion 322 may include a various structure in which the counted number of first end portions 410 in the second region 300b for absorption of the fluid of the liquid state is greater than the counted number of second end portions 420 connected to the first portion 321 in the first region 300a.

According to an embodiment, a thickness of the second portion 322 may be greater than a thickness of the first portion 321. For example, by extending from a base 311a of the first plate 311 to the second plate 312, the second portion 322 may contact the base 311a and the second plate 312. For example, the thickness of the first portion 321 may correspond to a height of a sidewall 311b of the first plate 311, but is not limited thereto. For example, the first portion 321 may be spaced apart from the second plate 312 by contacting the first plate 311. For example, a thickness of the first plate 311 may be smaller than the height of the sidewall 311b of the first plate 311.

For example, the first portion 321 may be attached to the first plate 311 to be spaced apart from the second plate 312 within the space S of the enclosure 310. The second portion 322 may be interposed between the first plate 311 and the second plate 312 to be attached to the first plate 311 and the second plate 312 within the space S. The structure of the second portion 322 interposed between the first plate 311 and the second plate 312 may be referred to as a center-filled wick structure for improving performance of the vapor chamber 300 by reducing pressure drop of the fluid in the second region 300b and the third region 300c, but is not limited thereto.

According to an embodiment, the first portion 321 of the wick structure 320 may fill an internal volume of the first region 300a when viewed the vapor chamber 300 from above. The second portion 322 of the wick structure 320 may include a first layer 322a attached on the first plate 311, and a second layer 322b overlapping the first layer 322a when viewed the vapor chamber 300 from above (e.g., the +z direction of FIG. 4B), and interposed between the first layer 322a and the second plate 312.

For example, the first portion 321 may cover the base 311a of the first plate 311 in the first region 300a. The first portion 321 may increase an area for receiving heat from the electronic component 30 by covering the base 311a in the first region 300a. The first portion 321 may be configured to form a first channel 451 for the fluid of/in the gaseous state formed between the first portion 321 and the second plate 312 by being spaced apart from the second plate 312. The vapor chamber 300 may have improved performance through the first portion 321 covering the base 311a and forming the first channel 451 in the first region 300a.

For example, the first layer 322a of the second portion 322 may be a layer attached to the first plate 311 (or the base 311a of the first plate 311) with the first portion 321. The second layer 322b may be a layer contacting the second plate 312 by being attached on the first layer 322a. For example, the second layer 322b may form the second channels 452 (or flow path(s)) for a flow of the fluid of/in the gaseous state in combination with the first layer 322a, by being interposed between the first layer 322a and the second plate 312. For example, the shape of the second layer 322b may have substantially the same shape as the first layer 322a, or a part thereof, to form one or more stem portions 430 of the second portion 322 and the plurality of branch portions 440 branching from the one or more stem portions 430 with the first layer 322a, but is not limited thereto. For example, the second layer 322b may provide the additional end portions different from the end portions of the first layer 322a by having the shape different from that of the first layer 322a in the second region 300b.

According to an embodiment, the space S of the enclosure 310 may include the first channel 451 formed by the first portion 321 of the wick structure 320 and the second channels 452 formed by the second portion 322 of the wick structure 320 and connected to the first channel 451. The first end portions 410 of the second portion 322 may be spaced apart from each other in order to move the fluid of/in the gaseous state to the first channel 451 through the second channels 452. For example, the space S defined by the enclosure 310 may include the plurality of channels 450 for movement of the fluid of/in the gaseous state, the plurality of channels 450 formed by the enclosure 310 and the wick structure 320 disposed in the space S. For example, the first channel 451 may be defined as a portion of the space S formed between the first portion 321 and the second plate 312 in the first region 300a. The fluid vaporized from the first portion 321 through the heat emitted from the electronic component 30 may move to the first channel 451. For example, the second channels 452 may be defined as the portion of the second portion 322 and/or the space S formed between the second portion 322 and/or the enclosure 310. Each of the second channels 452 may be connected or open to the first channel 451. The fluid moved to the first channel 451 may move from the first region 300a to the third region 300c and the second region 300b through the second channels 452 connected to the first channel 451.

For example, the second channels 452 may be defined by one or more stem portions 430 of the second portion 322. For example, the second channels 452 may include a channel 452a formed between the enclosure 310 and the first stem portion 431, a channel 452b formed between the first stem portion 431 and the second stem portion 432, a channel 452c formed between the second stem portion 432 and the third stem portion 433, and a channel 452d formed between the third stem portion 433 and the enclosure 310. Through each of the channels 452a, 452b, 452c, and 452d, the fluid of the gaseous state in the first region 300a may be moved to the second region 300b through the third region 300c.

According to an embodiment, a width of each of the second channels 452 in the second region 300b may be greater than a width of each of the second channels 452 in the third region 300c. For example, in the second channels 452 formed by one or more stem portions 430, the width of each of the second channels 452 in the third region 300c may be smaller than the width of each of the second channels 452 in the second region 300b by the structure of the vapor chamber 300 in which the internal volume (or the width) of the third region 300c is smaller than the internal volume (or the width) of the second region 300b. By having a relatively large width in the second region 300b, the second channels 452 may provide an additional space for the plurality of the branch portions 440 (or first end portions 410 of the second portion 322) branching from the one or more stem portions 430.

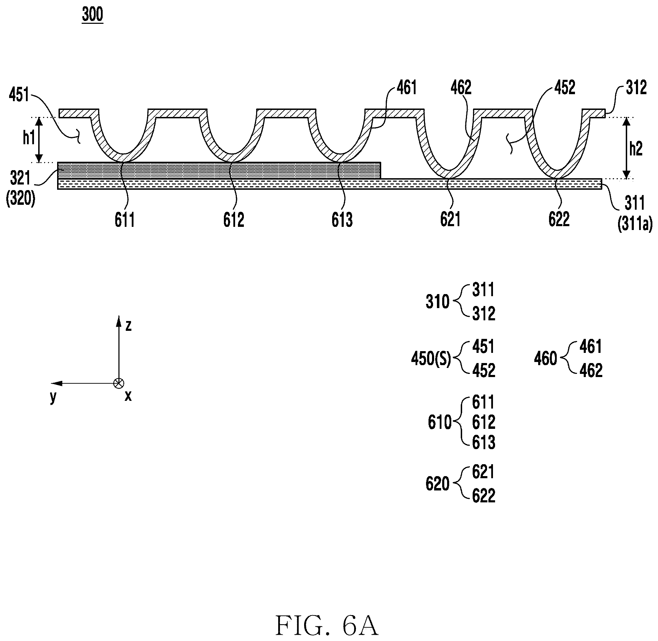

According to an embodiment, the second plate 312 may include the plurality of pillars 460 protruding toward the first plate 311 within the space S of the enclosure 310. For example, the plurality of pillars 460 may reduce damage to the enclosure 310 by an external impact by being configured to support the wick structure 320 and/or the first plate 311 in the enclosure 310. According to an embodiment, the enclosure 310 may be required to have a structure to reduce the damage to the enclosure 310 that may be caused by solidification or freezing of the fluid of/in the liquid state in the vapor chamber 300 in a gap between the plurality of pillars 460 and the first plate 311 and/or the wick structure 320. A structure of the enclosure 310 and/or the plurality of pillars 460 for reducing the damage to the enclosure 310 will be described later through an illustration and a description in FIG. 6A to FIG. 6C.

According to the above-described embodiment, the wick structure 320 of the vapor chamber 300 may improve the performance of the vapor chamber 300 by including the second portion 322 in which the number of first end portions 410 disposed in the second region 300b is greater than the number of the second end portions 420 connected to the first portion 321 in the first region 300a. The second portion 322 may increase a surface area of the second portion 322 of the wick structure 320 for absorbing the fluid of/in the liquid state in the second region 300b by including the plurality of branch portions 440 branching from one or more stem portions 430 defining the second end portions 420 in the second region 300b.

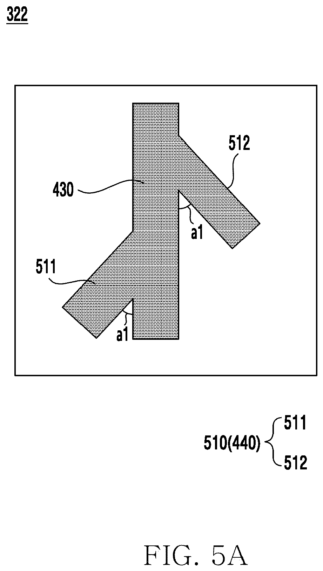

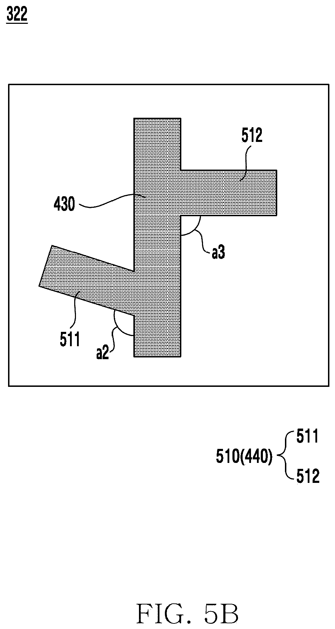

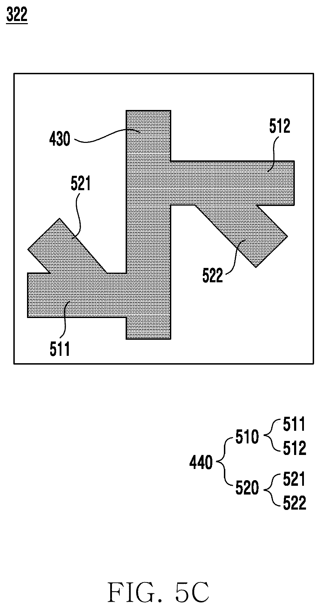

FIG. 5A, FIG. 5B, and FIG. 5C illustrate a portion of a wick structure of an exemplary vapor chamber.

Referring to FIG. 5A, FIG. 5B, and FIG. 5C, an electronic device (e.g., the electronic device 101 of FIG. 1) may include an electronic component (e.g., the electronic component 30 of FIG. 3A) and a vapor chamber (e.g., the vapor chamber 300 of FIG. 3A). The vapor chamber 300 may include a housing (e.g., the enclosure 310 of FIG. 3A) defining a space (e.g., the space S of FIG. 3B) for a fluid on the electronic component 30 and a wick structure (e.g., the wick structure 320 of FIG. 4B) disposed within the space S. The enclosure 310 may include a first region (e.g., the first region 300a of FIG. 3A) disposed at least partially over the electronic component 30 to receive heat emitted from the electronic component 30, a second region (e.g., the second region 300b of FIG. 3A) spaced apart from the first region 300a, and a third region (e.g., the third region 300c of FIG. 3A) connecting the first region 300a and the second region 300b, having smaller internal volume than the second region 300b. The wick structure 320 may include a first portion (e.g., the first portion 321 of FIG. 3B) disposed in the first region 300a, and a second portion 322 extending from a first portion 321, across the third region 300c, to the second region 300b. A counted number of first end portions (e.g., first end portions 410 of FIG. 4B) of the second portion disposed in the second region 300b may be greater than a counted number of second end portions (e.g., second end portions 420 of FIG. 4B) of the second portion 322 connected to the first portion 321 disposed in the first region 300a to absorb the fluid in the second region 300b. For example, the second portion 322 may include one or more stem portions 430 defining second end portions 420 by extending from the first portion 321, across the third region 300c, to the second region 300b, and a plurality of branch portions 440 defining at least a portion of the first end portions 410 by branching from each of the one or more stem portions 430 in the second region 300b. In other words, according to an example, a number of pieces extending from the first portion 321 in the first region 300a split, in the second region 300b, into a greater number of pieces which terminate in the second region 300b; where these pieces are collectively included in the second portion 322.

Hereinafter, an overlapping description of configurations having the same reference numerals as described in FIG. 4A and FIG. 4B will be omitted.

Referring to FIG. 5A, an angle between one or more stem portions 430 and the plurality of branch portions 440 may each have a preset angle a1. For example, the second portion 322 may include one or more stem portions 430 and first branch portions 510 branching from the one or more stem portions 430. Each of the first branch portions 510 may include a first branch portion 511 extending from a side of the one or more stem portions 430 to the angle a1 and a second branch portion 512 extending from another side opposite to the side of the one or more stem portions 430 to the angle a1. The above-mentioned embodiment is illustrative and is not limited thereto.

Referring to FIG. 5B, an angle between one or more stem portions 430 and at least a portion of the plurality of branch portions 440 may be different, respectively. For example, the second portion 322 may include one or more stem portions 430 and the first branch portions 510 branching from the one or more stem portions 430. Each of the first branch portions 510 may include the first branch portion 511 extending from a side of the one or more stem portions 430 to an angle a2 and the second branch portion 512 extending from another side opposite to the side of the one or more stem portions 430 to an angle a3 different from the angle a2. The above-mentioned embodiment is exemplary and is not limited thereto. For example, the angle between at least the portion of the plurality of branch portions 440 extending from one or more stem portions 430 and the one or more stem portions 430, a length of each of the plurality of branch portions 440 and a shape of each of the plurality of branch portions 440 may be different each other. The second portion 322 may increase an absorption rate of a fluid of a liquid state in the second region 300b by including the plurality of branch portions 440 extending from one or more stem portions 430 and each having a different shape.

When referring to FIG. 5C, the plurality of branch portions 440 may include the first branch portions 510 extending from one or more stem portions 430 and second branch portions 520 extending from the first branch portions 510. For example, the second portion 322 may include one or more stem portions 430 and the first branch portions 510 branching from the one or more stem portions 430. Each of the first branch portions 510 may include the first branch portion 511 extending from a side of the one or more stem portions 430 and the second branch portion 512 extending from another side opposite to the one side of the or more stem portions 430. The second portion 322 may include the second branch portions 520 branching from each of the first branch portions 510. The second branch portions 520 may include a third branch portion 521 extending from the first branch portion 511, and a fourth branch portion 522 extending from the second branch portion 512. However, the embodiment is not limited thereto, and for example, the plurality of branch portions 440 may include branch portions branching from the second branch portions 520. The second portion 322 may increase the absorption rate of the fluid of the liquid state in the second region 300b by including other branch portions branching from each of the plurality of branch portions 440 branching from one or more stem portions 430.

According to the above-described embodiment, the wick structure 320 of the vapor chamber 300 may improve the performance of the vapor chamber 300 by including the second portion 322 in which the counted number of first end portions 410 disposed in the second region 300b is greater than the counted number of the second end portions 420 connected to the first portion 321 in the first region 300a. The second portion 322 may have an increased surface area for absorbing the fluid of the liquid state in the second region 300b by including the plurality of branch portions 440 branching from one or more stem portions 430 defining the second end portions 420 in the second region 300b. The second portion 322 may increase the absorption rate of the fluid of the liquid state in the second region 300b by including a various shape in the plurality of the branch portions 440.

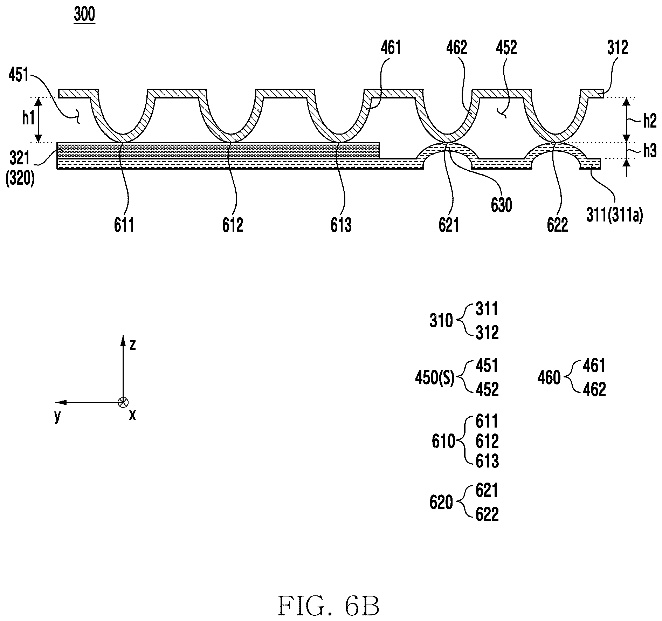

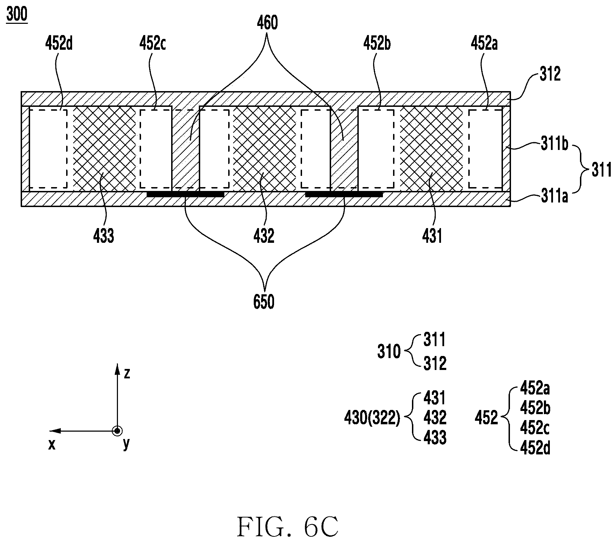

FIG. 6A and FIG. 6B are a partial cross-sectional view of an exemplary vapor chamber cut along line A-A' of FIG. 4B. FIG. 6C is a cross-sectional view of an exemplary vapor chamber cut along line B-B' of FIG. 4B.

Referring to FIG. 6A, FIG. 6B and FIG. 6C, an electronic device (e.g., the electronic device 101 of FIG. 1) may include an electronic component (e.g., the electronic component 30 of FIG. 3A) and a vapor chamber 300. The vapor chamber 300 may include an enclosure 310 defining a space S for a fluid on the electronic component 30 and a wick structure 320 disposed within the space S. The enclosure 310 may include a first region (e.g., the first region 300a of FIG. 3A) disposed at least partially over the electronic component 30 to receive heat emitted from the electronic component 30, a second region (e.g., the second region 300b of FIG. 3A) spaced apart from the first region 300a, and a third region (e.g., the third region 300c of FIG. 3A) connecting the first region 300a and the second region 300b, having smaller internal volume than the second region 300b. The wick structure 320 may include a first portion (e.g., the first portion 321 of FIG. 3B) disposed in the first region 300a, and a second portion 322 extending from the first portion 321, across the third region 300c, to the second region 300b. The enclosure 310 may include a first plate 311 and a second plate 312 including a plurality of pillars 460 (these may also be referred to as protrusions, irregular portions, indentations, extending portions etc.) coupled on or to the first plate 311 to seal the space S and protruding toward the first plate 311 in the space S.

According to an embodiment, the plurality of pillars 460 may include first pillars 461 having curvature respectively to form first points 610 contacting the first portion 321 of the wick structure 320 in the first region 300a, and second pillars 462 having curvature respectively to form second points contacting the first plate 311. For example, the first pillars 461 may face the first portion 321 of the wick structure 320 in the first region 300a. The first pillars 461 may be disposed in the first channel 451 formed by the enclosure 310 and the first portion 321. The first pillars 461 may include points 611, 612, and 613 configured to contact the first portion 321 by including a curved surface, respectively, so as to be in point contact with the first portion 321. Each of the first pillars 461 may reduce damage to the enclosure 310 that may be caused by freezing a fluid of/in a gaseous state in the first channel 451 between the first portion 321 and the first pillars 461, by being configured to reduce or minimize an area contacting the first portion 321 (e.g. by providing the curved surface at the point of contact). For example, the second pillars 462 may face a base 311a of the first plate 311 in the second region 300b, and the third region 300c. The second pillars 462 may be disposed in a/the second channel 452 formed by the enclosure 310 and the second portion 322. The second pillars 462 may include points 621, and 622 configured to contact the base 311a by including a curved surface, respectively, so as to be in point contact with the base 311a. The second pillars 462, by being configured to reduce or minimize an area respectively contacted with the base 311a (e.g. via having the curved surface at the point of contact), may reduce the damage to the enclosure 310 due to freezing of the fluid of/in the gaseous state in the second channels 452 between the base 311a and the second pillars 462. For example, compared to a case where pillars with flat surfaces at the point of contact with the first portion 321 or base 311a of the first plate 311 are provided, said damage to the enclosure 310 (due to freezing) may be reduced by instead providing the first pillars 461 and/or second pillars 462 with the curved surfaces as disclosed above.

When referring to FIG. 6A, a length h2 of each of the second pillars 462 may be greater than a length h1 of each of the first pillars 461. For example, the plurality of pillars 460 may extend from the second plate 312 toward the base 311a (e.g., in a -z direction). Since a stepped structure is formed in the space S of the enclosure 310 by the first portion 321 in the first region 300a, the length h2 of each of the second pillars 462 may be greater than the length h1 of the first pillars 461 facing the first portion 321.

For example, when referring to FIG. 6B, the length h2 of each of the second pillars 462 may correspond to the length h1 of each of the first pillars 461. The first plate 311 may include third pillars 630 protruding from the first plate 311 toward the second plate 312 to face the second pillars 462 respectively. For example, each of the third pillars 630 may be formed at a position of the first plate 311 corresponding to a position where each of the second pillars 462 of the second plate 312 is formed. A length h3 of each of the third pillars 630 may correspond to a thickness of the first portion 321 configured to contact the first pillars 461 in the first region 300a. The third pillars 630 may each have a curved surface at a point where they contact a corresponding second pillar 462.

According to an embodiment, the vapor chamber 300 may include a hydrophobic substance 650, attached to the first plate 311, to be at least partially disposed between the second pillars 462 and the first plate 311. For example, when referring to FIG. 6C, the hydrophobic substance 650 may be disposed in the second channels 452 to face the plurality of pillars 460, respectively. For example, the hydrophobic substance 650 may be applied to a portion of each of the plurality of pillars 460 facing the first plate 311, and/or may be applied on a portion of the first plate 311 facing each of the plurality of pillars 460. However, the above-described embodiment is exemplary and is not illustrated, but when referring to FIG. 6A and FIG. 6B together, the hydrophobic substance 650 may be at least partially disposed between the first portion 321 and the plurality of pillars 460 in the first region 300a. The vapor chamber 300 may reduce interposition of the fluid between the plurality of pillars 460 and the first plate 311, by including the hydrophobic substance 650 configured to face each of the plurality of pillars 460.

According to the above-described embodiment, the enclosure 310 of the vapor chamber 300 may reduce damage to the enclosure 310 that may be caused by the fluid of/in the gaseous state freezing between the first plate 311 and the second pillars 462, by including the plurality of pillars 460 configured to reduce or minimize the area contacting the first plate 311 and/or the first portion 321 of the wick structure 320 in the second plate 312. The vapor chamber 300 may reduce the damage to the enclosure 310 that may be caused by the fluid of/in the gaseous state freezing between the first plate 311 and the second pillars 462, by including the third pillars 630 of the first plate 311 facing each of the plurality of pillars 460 and/or the hydrophobic substance 650 facing each of the plurality of pillars 460.

According to an embodiment, the electronic device (e.g., the electronic device 101 of FIG. 1) may include a heat generating component (e.g., the processor 120 of FIG. 1, the electronic component 30 of FIG. 3A), and a vapor chamber (e.g., the vapor chamber 300 of FIG. 3A), disposed over the heat generating component. The vapor chamber may include an enclosure (e.g., the enclosure 310 of FIG. 3A), a fluid in the enclosure, and a wick structure (e.g., the wick structure 320 of FIG. 3B) in the enclosure. The wick structure may include a first portion (e.g., the first portion 321 of FIG. 3B) disposed at least partially over the heat generating component. A state of the fluid positioned in the first portion may be changed from a liquid state to a gaseous state by heat transmitted from the heat generating component to the first portion. The fluid of the gaseous state may diffuse to an internal space (e.g., the space S of FIG. 3B) of the enclosure. The wick structure may include a second portion (e.g., the second portion 322 disposed in the second region 300c of FIG. 3B) configured to absorb the fluid of the liquid state changed, within the internal space of the enclosure, from the gaseous state. The wick structure may include a third portion (e.g., a second portion 322 disposed in the third region 300c of FIG. 3B) disposed between the first portion and the second portion. The fluid of the liquid state absorbed by the second portion may be moved through the third portion to the first portion. A width (e.g., w2 of FIG. 3A) of a portion of the internal space of the enclosure surrounding the third portion may be smaller than a width (e.g., w1 of FIG. 3A) of a portion of the internal space of the enclosure surrounding the second portion. The third portion may include one or more elongated stem portions (e.g., one or more stem portions 430 disposed in the third region 300c of FIG. 4B) extending from the first portion. The second portion may include one or more elongated stem portions (e.g., one or more stem portions 430 disposed in the second region 300b of FIG. 4B) extending from the one or more elongated stem portions of the third portion. The second portion may include a plurality of branch portions (e.g., a plurality of branch portions 440 of FIG. 4B) extending from the one or more elongated stem portions of the second portion. The plurality of branch portions may be spaced apart from each other. A counted number of the plurality of branch portions of the second portion may be greater than a counted number of the one or more elongated stem portions of the third portion.

A portion of the internal space of the enclosure surrounding the first portion may be offset with respect to the portion of the internal space of the enclosure surrounding the second portion.

For example, each of angles between the one or more elongated stem portions of the second portion and at least some of the plurality of branch portions connected with the one or more elongated stem portions of the second portion may be different from each other.

For example, the plurality of branch portions may include first branch portions extending from the one or more elongated stem portions of the second portion, and second branch portions extending from the first branch portions.

For example, the enclosure may include a first section (e.g., the first region 300a of FIG. 3A), surrounding the first portion of the wick structure, and disposed over the heat generating component for vaporization of the fluid by receiving heat emitted from the heat generating component. The enclosure may include a second section (e.g., the second region 300b of FIG. 3A), surrounding the second portion of the wick structure, and spaced apart from the first section for condensation of the fluid. The enclosure may include a third section, surrounding the third portion of the wick structure by connecting the first section and the second section, and having smaller internal volume than the first section and the second section. The counted number of the plurality of branch portions of the second portion surrounded by the second section may be greater than the counted number of the one or more elongated stem portions of the third portion surrounded by the third section to increase absorption of the fluid of the liquid state.

For example, the internal space may include a first channel (e.g., the first channel 451 of FIG. 4B), formed by the first portion. The internal space may include second channels (e.g., second channels 452 of FIG. 4B), formed by the second portion and the third portion, connected to the first channel to move the fluid of the gaseous state from the first section, across the third section, to the second section. The plurality of branch portions of the second portion may be paced apart from each other for moving of the fluid of the gaseous state, through the second channels, to the first channel.

For example, a width of each of the second channels within the second section may be greater than a width of each of the second channels within the third section.

For example, a thickness of the second portion and a thickness of the third portion may be greater than a thickness of the first portion.

For example, the enclosure may include a first plate (e.g., the first plate 311 of FIG. 3B), and a second plate (e.g., the second plate 312 of FIG. 3A) coupled on the first plate to seal the internal space. The first portion may be attached to the first plate and may be spaced apart from the second plate within the internal space. The second portion and the third portion may be interposed between the first plate and the second plate within the internal space.

For example, the wick structure may further include a first layer, defined by the second portion and the third portion, and attached on the first plate. The wick structure may further include a second layer, defined by the second portion and the third portion, and overlapping the first layer when viewed the vapor chamber from above by being interposed between the first layer and the second plate.

For example, the second portion may have a leaf-vein fractal shape by the plurality of branch portions.

For example, the enclosure may further include a first plate, and a second plate, coupled on the first plate to seal the internal space, and including a plurality of pillars (e.g., the plurality of pillars 460 of FIG. 4A) protruding toward the first plate within the internal space. The plurality of pillars may include first pillars (e.g., first pillars 461 of FIG. 6A) having curvature respectively to form first points contacting the first portion of the wick structure. The plurality of pillars may include second pillars (e.g., second pillars 462 of FIG. 6A) having curvature respectively to form second points contacting the first plate.

For example, a length (e.g., h2 of FIG. 6A) of each of the second pillars may be greater than a length (e.g., h1 of FIG. 6A) of each of the first pillars.

For example, a length of each of the first pillars may correspond to a length of each of the second pillars. The first plate may include third pillars (e.g., third pillars 640 of FIG. 6B) protruding from the first plate toward the second plate to face the second pillars respectively.

For example, the vapor chamber may further include a hydrophobic substance (e.g., the hydrophobic substance 650 of FIG. 6C), attached to the first plate, to be at least partially disposed between the second pillars and the first plate.

According to an embodiment, the electronic device may include a heat generating component, and a vapor chamber. The vapor chamber may define an internal space disposed over the heat generating component, and include an enclosure including a first plate, and a second plate coupled on the first plate to seal the internal space. The vapor chamber may include a fluid within the internal space and a wick structure within the internal space for cooling the heating component. The internal space may include a first space, at least partially disposed over the heat generating component for vaporization of the fluid by receiving heat emitted from the heat generating component. The internal space may include a second space spaced apart from the first space for condensation of the fluid. The internal space may include a third space connecting the first space and the second space, and having a smaller width than the second space. The wick structure may include a first portion (e.g., the first portion 321 of FIG. 3B) disposed within the first space and in which the fluid within the first space is changed from a liquid state to a gaseous state. The wick structure may include one or more stem portions (e.g., one or more stem portions 430 of FIG. 4B) extending from the first portion, across the third space, to the second space, and a second portion (e.g., the second portion 322 of FIG. 3B) including a plurality of branches (e.g., the plurality of branches 440 of FIG. 4B) branching from the one or more stem portions to increase absorption of a fluid in the liquid state condensed within the second space. The first portion may be attached to the first plate and may be spaced apart from the second plate within the internal space. The second portion may be interposed between the first plate and the second plate within the internal space.

For example, the plurality of branch portions may include first branch portions extending from the one or more stem portions, and second branch portions extending from the first branch portions.

For example, the first portion may fill the first space when viewed the vapor chamber from above. The second portion may include a first layer attached on the first plate. The second portion may include a second layer overlapping the first layer when viewed the vapor chamber from above, and interposed between the first layer and the second plate.

For example, the second plate, within the space, may include a plurality of pillars including first pillars having curvature respectively to form first points contacting the first portion, and second pillars having curvature respectively to form second points contacting the first plate. A length of each of the second pillars may be greater than a length of each of the first pillars.

For example, the second portion has a leaf-vein fractal shape by the plurality of branch portions.

According to an embodiment, the electronic device (e.g., the electronic device 101 of FIG. 1) may include an electronic component (e.g., the processor 120 of FIG. 1, the electronic component 30 of FIG. 3A), an enclosure (e.g., the enclosure 310 of FIG. 3A) defining a space (e.g., the space S of FIG. 3B) for a fluid on the electronic component, and a vapor chamber (e.g., the vapor chamber 300 of FIG. 3A) including a wick structure (e.g., the wick structure 320 of FIG. 3B) disposed within the space. The enclosure may include a first region (e.g., the first region 300a of FIG. 3A) at least partially disposed over the electronic component to receive heat emitted from the electronic component, a second region (e.g., the second region 300b of FIG. 3A) spaced apart from the first region, and a third region (e.g., the third region 300c of FIG. 3A) connecting the first region and the second region, having smaller internal volume than the second region. The wick structure may include a first portion (e.g., the first portion 321 of FIG. 3B) disposed in the first region, and a second portion (e.g., the second portion 322 of FIG. 3B) extending from the first portion, across the third region, to the second region. A counted number of first end portions (e.g., the first end portions 410 of FIG. 4B) of the second portion disposed in the second region may be greater than a counted number of second end portions (e.g., the second end portions 420 of FIG. 4B) of the second portion connected to the first portion disposed in the first region to absorb the fluid in the second region.

For example, the second portion may include one or more stem portions (e.g., the one or more stem portions 430 of FIG. 4B) defining the second end portions by extending from the first portion, across the third region, to the second region. The second portion may include a plurality of branch portions (e.g., the plurality of branch portions 440 of FIG. 4B) defining at least a portion of the first end portions by branching from each of the one or more stem portions in the second region.

For example, the first end portions may include a third end portions (e.g., the third end portions 411 of FIG. 4B) defined by the one or more stem portions and a fourth end portions (e.g., the fourth end portions 412 of FIG. 4B) defined by the plurality of the branch portions. Each of the plurality of the branch portions may extend from portions connecting the second end portions and the third end portions of the one or more stem portions.

For example, an angle between the one or more stem portions and at least some of the plurality of the branch portions may be different from each other.

For example, the plurality of the branch portions may include first branch portions (e.g., first branch portions 510 of FIG. 5C) extending from the one or more stem portions, and second branch portions (e.g., the second branch portions 520 of FIG. 5C) extending from the first branch portions.

For example, the space may include a first channel (e.g., the first channel 451 of FIG. 4B), formed by the first portion, and second channels (e.g., the second channels 452 of FIG. 4B), formed by the second portion, connected to the first channel. The first end portions may be spaced apart from each other for moving of the fluid of the gaseous state, through the second channels, to the first channel.

For example, a width of each of the second channels in the second region may be greater than a width of each of the second channels in the third region.

For example, a thickness of the second portion may be smaller than a thickness of the first portion.

For example, the enclosure may further include a first plate (e.g., the first plate 311 of FIG. 3B), and a second plate (e.g., the second plate 312 of FIG. 3A) coupled on the first plate to seal the space. The first portion may be attached to the first plate to be spaced apart from the second plate within the space. The second portion may be interposed between the first plate and the second plate to be attached to the first plate and the second plate within the space.

For example, the first portion may fill an internal volume of the first region when viewed the vapor chamber from above. The second portion may include a first layer attached on the first plate, and a second layer overlapping the first layer when viewed the vapor chamber from above, and interposed between the first layer and the second plate.

For example, the second portion may have a leaf-vein fractal shape by the first end portions in the second region.

For example, the enclosure may further include a first plate, and a second plate, coupled on the first plate to seal the space, including a plurality of pillars (e.g., the plurality of pillars 460 of FIG. 4A) protruding toward the first plate within the space. The plurality of pillars may include first pillars (e.g., the first pillars 461 of FIG. 6A) having curvature respectively to form first points contacting the first portion of the wick structure in the first region. The plurality of pillars may include second pillars (e.g., the second pillars 462 of FIG. 6A) having curvature respectively to form second points contacting the first plate.

For example, a length (e.g., the length h2 of FIG. 6A) of each of the second pillars may be greater than a length (e.g., the length h1 of FIG. 6A) of each of the first pillars.

For example, the length of each of the first pillars may correspond to the length of each of the second pillars. The first plate may include third pillars (e.g., third pillars 640 of FIG. 6B) protruding from the first plate toward the second plate to face the second pillars respectively.

For example, the vapor chamber may further include a hydrophobic substance (e.g., the hydrophobic substance 650 of FIG. 6C), attached to the first plate, to be at least partially disposed between the second pillars and the first plate.

An electronic device according to an embodiment may include an electronic component. The electronic device may include a first plate, a second plate coupled on the first plate, an enclosure including a space for a fluid on the electronic component between the first plate and the second plate, and a vapor chamber including a wick structure disposed within the space. The enclosure may define a first region at least partially disposed over the electronic component to receive heat emitted from the electronic component, a second region spaced apart from the first region, and a third region connecting the first region and the second region, having smaller internal volume than the second region. The wick structure may include a first portion disposed in the first region, and a second portion including one or more stem portions extending from the first portion, across the third region, to the second region, and a plurality of branch portions branching respectively from the one or more stem portions in the second region. The first portion may be spaced apart from the second plate by being attached to the first plate within the space. The second portion may be interposed between the first plate and the second plate to be attached to the first plate and the second plate within the space.

The plurality of branch portions may include first branch portions extending from the one or more stem portions, and second branch portions extending from the first branch portions.

For example, the first portion may fill an internal volume of the first region when viewed the vapor chamber from above. The second portion may include a first layer attached on the first plate, and a second layer overlapping the first layer when viewed the vapor chamber from above, and interposed between the first layer and the second plate.

For example, the second plate, within the space, may include a plurality of pillars including first pillars having curvature respectively to form first points contacting the first portion, and second pillars having curvature respectively to form second points contacting the first plate. A length of each of the second pillars may be greater than a length of each of the first pillars.

For example, the second portion may have a leaf-vein fractal shape by the branch portions in the second region.

It will be appreciated that various examples of the present disclosure provide a wick structure according to any description above, i.e. separate to the electronic device, heat generating component, enclosure and fluid. For example, there is provided a wick structure for a vapor chamber, the wick structure comprising: a first portion, wherein a state of a fluid located in the first portion is changed from a liquid state to a gaseous state by heat received by the first portion from an external source, and wherein the fluid in the gaseous state diffuses to a space surrounding of the first portion; a second portion configured to absorb the fluid in the liquid state, wherein the fluid in the gaseous state diffuses to a space surrounding of the second portion from the space surrounding of the first portion and a state of the fluid in the gaseous state is changed, in the surrounding of the second portion, to the liquid state; and a third portion disposed between the first portion and the second portion, wherein the fluid of the liquid state absorbed by the second portion is moved through the third portion to the first portion; wherein the third portion comprises: one or more first stem portions extending from the first portion; wherein the second portion comprises: one or more second stem portions each extending from one of the one or more first stem portions, and a plurality of branch portions each extending from one of the one or more second stem portions, the plurality of branch portions being spaced apart from each other; and wherein a number of the plurality of branch portions is greater than a number of the one or more first stem portions. For example, a cross-sectional width of a space surrounding the third portion is smaller than a corresponding cross-sectional width of the space surrounding the second portion. It will be appreciated that, in other examples, this wick structure is modified to include any of the additional features or details described above, such as the plurality of branch portions including: a first branch portion extending from the one or more second stem portions; and a second branch portion extending from the first branch portions.

The present disclosure also include the following numbered examples:
According to a first example, there is provided An electronic device comprising: a heat emitting component; and a vapor chamber including: an enclosure; a fluid in the enclosure; and a wick structure in the enclosure, the wick structure including: a first portion, wherein a state of the fluid located in the first portion is changed from a liquid state to a gaseous state by heat from the heat emitting component, and wherein the fluid in the gaseous state diffuses to an internal space of the enclosure from the first portion; a second portion configured to absorb the fluid in the liquid state, wherein the state of the fluid in the gaseous state is changed, in the internal space of the enclosure, to the liquid state; and a third portion disposed between the first portion and the second portion and configured to transfer the fluid in the liquid state absorbed by the second portion to the first portion, wherein a width of a portion of the internal space of the enclosure surrounding the third portion is smaller than a width of a portion of the internal space of the enclosure surrounding the second portion, wherein the third portion comprises: one or more first stem portions extending from the first portion, wherein the second portion comprises: one or more second stem portions extending from the one or more first stem portions; and a plurality of branch portions extending from the one or more second stem portions, the plurality of branch portions being spaced apart from each other, and wherein a number of the plurality of branch portions is greater than a number of the one or more first stem portions.

According to a second example, there is provided the electronic device of the first example, wherein a portion of the internal space of the enclosure surrounding the first portion is offset with respect to the portion of the internal space of the enclosure surrounding the second portion.

According to a third example, there is provided the electronic device of the first example or the second example, wherein each branch portion of at least two of the plurality of branch portions is configured to extend at a different angle to another branch portion of the at least two of the plurality of branch portions.

According to a fourth example, there is provided the electronic device of any one of the first example to the third example, wherein the plurality of branch portions include: one or more first branch portions extending from the one or more second stem portions; and one or more second branch portion extending from the one or more first branch portions.

According to a fifth example, there is provided the electronic device of any one of the first example to the fourth example, wherein the enclosure includes: a first section disposed over the heat generating component and configured to surround the first portion of the wick structure and receive the fluid in the gaseous state vaporized by the heat emitted from the heat generating component; a second section spaced apart from the first section and configured to surround the second portion of the wick structure, and condense the fluid in the gaseous state; and a third section configured to surround the third portion of the wick structure by connecting the first section and the second section, and have smaller volume than the first section or the second section.

According to a sixth example, there is provided the electronic device of the fifth example, wherein the internal space of the enclosure includes: a first channel, formed by the first portion; and second channels, formed by the second portion and the third portion, connected to the first channel and through which the fluid of the gaseous state is transferred from the first section, across the third section, to the second section, wherein the second channels are spaced apart according to the plurality of branch portions being spaced apart from each other.

According to a seventh example, there is provided the electronic device of the sixth example, wherein a width of each of the second channels within the second section is greater than a width of each of the second channels within the third section.

According to an eighth example, there is provided the electronic device of any one of the first example to the seventh example, wherein a thickness of the second portion and a thickness of the third portion are greater than a thickness of the first portion.

According to a ninth example, there is provided the electronic device of any one of the first example to the eighth example, wherein the enclosure includes: a first plate; and a second plate coupled to the first plate to seal the internal space, wherein the first portion is attached to the first plate and is spaced apart from the second plate within the internal space, wherein the second portion and the third portion are interposed between the first plate and the second plate within the internal space.

According to a tenth example, there is provided the electronic device of the ninth example, wherein the wick structure further includes: a first layer, defined by the second portion and the third portion, attached on the first plate; and a second layer, defined by the second portion and the third portion, overlapping the first layer when viewed the vapor chamber from above by being interposed between the first layer and the second plate.

According to an eleventh example, there is provided the electronic device of any one of the first example to the tenth example, wherein the plurality of branch portions form a leaf-vein fractal shape in the second portion.

According to a twelfth example, there is provided the electronic device of any one of the first example to the eleventh example, wherein the enclosure further includes: a first plate; and a second plate coupled on the first plate to seal the internal space and including a plurality of pillars protruding toward the first plate within the internal space, wherein the plurality of pillars include: one or more first pillars having curvature respectively to form first points contacting the first portion of the wick structure; and one or more second pillars having curvature respectively to form second points contacting the first plate.

According to a thirteenth example, there is provided the electronic device of the twelfth example, wherein a length of each of the one or more second pillars is greater than a length of each of the one or more first pillars.

According to a fourteenth example, there is provided the electronic device of the twelfth example, wherein a length of each of the one or more first pillars is equal to a length of each of the one or more second pillars, wherein the first plate includes one or more third pillars each protruding from the first plate toward the second plate to face a corresponding one of the one or more second pillars.

According to a fifteenth example, there is provided the electronic device of any one of the twelfth example to the fourteenth example, wherein, the vapor chamber further includes a hydrophobic substance provided on the first plate to be at least partially disposed between the second pillars and the first plate.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above. It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "connected with", or "attached to" another element (e.g., a second element), it means that the element may be coupled with the other element directly (e.g., wiredly), wirelessly, or via a third element (i.e. indirect coupling or attachment).

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a heat generating component (30); and
a vapor chamber (300) including:
an enclosure (310);
a fluid in the enclosure (310); and
a wick structure (320) in the enclosure (310), the wick structure (320) including:
a first portion (321), wherein a state of the fluid located in the first portion (321) is changed from a liquid state to a gaseous state by heat from the heat generating component (30) , and wherein the fluid in the gaseous state diffuses to an internal space (S) of the enclosure (310) from the first portion (321);
a second portion (322) configured to absorb the fluid in the liquid state, wherein the state of the fluid in the gaseous state is changed, in the internal space (S) of the enclosure (310), to the liquid state; and
a third portion (323) disposed between the first portion (321) and the second portion (322) and configured to transfer the fluid in the liquid state absorbed by the second portion (322) to the first portion (321),
wherein a width of a portion of the internal space (S) of the enclosure (310) surrounding the third portion (323) is smaller than a width of a portion of the internal space (S) of the enclosure (310) surrounding the second portion (322),
wherein the third portion (323) comprises:
one or more first stem portions extending from the first portion (321),
wherein the second portion (322) comprises:
one or more second stem portions extending from the one or more first stem portions; and
a plurality of branch portions (440) extending from the one or more second stem portions, the plurality of branch portions (440) being spaced apart from each other, and
wherein a number of the plurality of branch portions (440) is greater than a number of the one or more first stem portions.

2. The electronic device (101) of claim 1,
wherein a portion of the internal space (S) of the enclosure (310) surrounding the first portion (321) is offset with respect to the portion of the internal space (S) of the enclosure (310) surrounding the second portion (322).

3. The electronic device (101) of claim 1 or 2,
wherein each branch portion of at least two of the plurality of branch portions (440) is configured to extend at a different angle to another branch portion of the at least two of the plurality of branch portions (440).

4. The electronic device (101) of any one of claims 1 to 3,
wherein the plurality of branch portions (440) include:
first branch portions (510) extending from the one or more second stem portions; and
second branch portions (520) extending from the first branch portions (510).

5. The electronic device (101) of any one of claims 1 to 4,
wherein the enclosure (310) includes:
a first section (300a), surrounding the first portion (321) of the wick structure (320), disposed over the heat generating component (30) for vaporization of the fluid by receiving heat emitted from the heat generating component (30);
a second section (300b), surrounding the second portion (322) of the wick structure (320), spaced apart from the first section (300a) for condensation of the fluid; and
a third section (300c), surrounding the third portion (323) of the wick structure (320) by connecting the first section (300a) and the second section (300b), having smaller internal volume than the first section (300a) and the second section (300b),
wherein the counted number of the plurality of branch portions (440) of the second portion (322) surrounded by the second section (300b) is greater than the counted number of the one or more elongated stem portions of the third portion (323) surrounded by the third section (300c) to increase absorption of the fluid of the liquid state.

6. The electronic device (101) of claim 5,
wherein the internal space (S) includes:
a first channel (451), formed by the first portion (321); and
second channels (452), formed by the second portion (322) and the third portion (323), connected to the first channel (451) to move the fluid of the gaseous state from the first section (300a), across the third section (300c), to the second section (300b),
wherein the plurality of branch portions (440) of the second portion (322) are spaced apart from each other for moving of the fluid of the gaseous state, through the second channels (452), to the first channel (451).

7. The electronic device (101) of claim 6,
wherein a width of each of the second channels (452) within the second section (300b) is greater than a width of each of the second channels (452) within the third section (300c).

8. The electronic device (101) any one of claims 1 to 7,
wherein a thickness of the second portion (322) and a thickness of the third portion (323) are greater than a thickness of the first portion (321).

9. The electronic device (101) any one of claims 1 to 8,
wherein the enclosure (310) includes:
a first plate (311); and
a second plate (312) coupled on the first plate (311) to seal the internal space (S),
wherein the first portion (321) is attached to the first plate (311) and is spaced apart from the second plate (312) within the internal space (S),
wherein the second portion (322) and the third portion (323) are interposed between the first plate (311) and the second plate (312) within the internal space (S).

10. The electronic device (101) of claim 9,
wherein the wick structure (320) further includes:
a first layer (322a), defined by the second portion (322) and the third portion (323), attached on the first plate (311); and
a second layer (322b), defined by the second portion (322) and the third portion (323), overlapping the first layer (322a) when viewed the vapor chamber (300) from above by being interposed between the first layer (322a) and the second plate (312).

11. The electronic device (101) any one of claims 1 to 10,
wherein the second portion (322) has a leaf-vein fractal shape by the plurality of branch portions (440).

12. The electronic device (101) any one of claims 1 to 11,
wherein the enclosure (310) further includes:
a first plate (311); and
a second plate (312), coupled on the first plate (311) to seal the internal space (S), including a plurality of pillars (460) protruding toward the first plate (311) within the internal space (S),
wherein the plurality of pillars (460) include:
first pillars (461) having curvature respectively to form first points (610) contacting the first portion (321) of the wick structure (320); and
second pillars (462) having curvature respectively to form second points (620) contacting the first plate (311).

13. The electronic device (101) of claim 12,
wherein a length (h2) of each of the second pillars (462) is greater than a length (h1) of each of the first pillars (461).

14. The electronic device (101) of claim 12,
wherein a length (h1) of each of the first pillars (461) corresponds to a length (h1) of each of the second pillars (462),
wherein the first plate (311) includes a third pillars (630) protruding from the first plate (311) toward the second plate (312) to face the second pillars (462) respectively,

15. The electronic device (101) of any one of claims 12 to 14,
wherein, the vapor chamber (300) further includes a hydrophobic substance (650), attached to the first plate (311), to be at least partially disposed between the second pillars (462) and the first plate (311).
